# EUROPEAN PATENT APPLICATION

(11) **EP 4 826 703 A1**
(43) Date of publication of application: **21.10.2026**
(21) Application number: 24916779.2
(22) Date of filing: 28.12.2024
(51) Int. Cl.: G09F 9/30

(54) **EDGE PROTECTION ASSEMBLY AND FOLDABLE DEVICE**

(30) Priority: 11.01.2024 CN 202410047842
(71) Applicant: Huawei Technologies Co., Ltd., Shenzhen, Guangdong 518129 (CN)
(72) Inventor: LIU, Yu, Shenzhen, Guangdong 518129 (CN); CHEN, Yiyang, Shenzhen, Guangdong 518129 (CN); CAO, Jianbo, Shenzhen, Guangdong 518129 (CN); XIA, Chuxue, Shenzhen, Guangdong 518129 (CN); LIU, Guoqing, Shenzhen, Guangdong 518129 (CN)
(74) Representative: Huawei European IPR
(86) International application number: PCT/CN2024/143481
(87) International publication number: WO 2025/148732

(57) **Abstract**

This application provides an edge protection assembly (100) and a foldable device (1000). The edge protection assembly (100) includes a fastening member (110) and a flexible insert (120). The flexible insert (120) is of an integrally formed structure from an elastic sheet (121) and a flexible body (122), the flexible body (122) is prone to bending and deformation, and the elastic sheet (121) plays a reinforcement role. The elastic sheet (121) is embedded in a strip portion (1221) of the flexible body (122), and a first connecting portion (1222) and a second connecting portion (1223) are correspondingly connected to two ends (1221a, 1221b) of the strip portion (1221). The first connecting portion (1222) and the second connecting portion (1223) are correspondingly embedded in an edge (400a) of a first main body (400) and an edge (500a) of a second main body (500). The fastening member (110) is fastened to a hinge assembly (200). A middle part (1221f) of the strip portion (1221) is limited by a protruding portion (111) of the fastening member (110), and the strip portion (1221) may be bent around the protruding portion (111). The strip portion (1221) can keep covering an edge of a bending region (302) of a display surface (300a) of a flexible display (300), to protect an edge of the bending region (302). Under prolonged repeated bending, static bending, or high-temperature and high-humidity conditions, the flexible insert (120) is not prone to creasing, arching, and detachment. The flexible insert (120) facilitates formation of a uniform bending form during bending of the flexible display (300), and prevents the flexible display (300) from sustaining crack damage due to compression.

## Description

This application claims priority to Chinese Patent Application No. 202410047842.6, filed with the China National Intellectual Property Administration on January 11, 2024 and entitled "EDGE PROTECTION ASSEMBLY AND FOLDABLE DEVICE", which is incorporated herein by reference in its entirety.

### TECHNICAL FIELD

Embodiments of this application relate to the technical field of electronic devices, and in particular, to an edge protection assembly and a foldable device.

### BACKGROUND

When a foldable device in a related technology is in an unfolded state, a flexible display can provide a display region with a large area, and when the foldable device is in a folded state, an entire device structure is compact, and portability is good. An edge protection assembly may be disposed at a position of an edge of a bending region of the flexible display, to shield and protect the edge of the bending region of the flexible display. The edge protection assembly in the related technology is prone to plastic deformation after being bent for a long time, has difficulty restoring to a natural form when being in an unfolded state, and is prone to problems of creasing and arching.

### SUMMARY

Embodiments of this application provide an edge protection assembly and a foldable device, to resolve a problem that an edge protection assembly in a related technology is prone to creasing and arching after being bent for a long time.

The following technical solutions are used in embodiments of this application.

According to a first aspect, the edge protection assembly provided in embodiments of this application is applied to a foldable device having a hinge assembly, a first main body, a second main body, and a flexible display. The edge protection assembly includes a fastening member and a flexible insert, and the fastening member is configured to be fastened to the hinge assembly. In an axial direction of the hinge assembly, a projection of the fastening member covers a part of a side surface of the flexible display. The fastening member has a protruding portion. The flexible insert includes an elastic sheet and a flexible body, and the elastic sheet and the flexible body are of an integrally formed structure. The flexible body includes a strip portion, a first connecting portion, and a second connecting portion. The first connecting portion is connected to one end of the strip portion, the second connecting portion is connected to the other end of the strip portion, and the elastic sheet is embedded in the strip portion. The strip portion has a first surface and a second surface that face away from each other, the first surface and an edge of a bending region of the display surface of the flexible display are disposed facing each other, and the protruding portion and the second surface are disposed facing each other at a middle part of the strip portion in a length direction. The first connecting portion is configured to be embedded in an edge of the first main body, and the second connecting portion is configured to be embedded in an edge of the second main body.

An arrangement direction of a first main body and a second main body of the foldable device in an unfolded state is defined as an X direction, a width direction of the foldable device or an axial direction of the hinge assembly is defined as a Y direction, a thickness direction of the foldable device is defined as a Z direction, the thickness direction of the flexible display in an unfolded state is also defined as the Z direction, and the X direction, the Y direction, and the Z direction are perpendicular to each other.

The side surface of the flexible display is an outer circumferential surface connecting the display surface and a back surface. The length direction (X direction) of the strip portion is a length direction of the strip portion when the foldable device is in the unfolded state. The length direction (X direction) of the strip portion is perpendicular to the axial direction (Y direction) of the hinge assembly.

According to the edge protection assembly provided in this embodiment of this application, the flexible insert is of an integrally formed structure of the elastic sheet and the flexible body, the flexible body is prone to bending and deformation, and the elastic sheet plays a reinforcement role. The elastic sheet is embedded in a strip portion of the flexible body, and the first connecting portion and the second connecting portion are correspondingly connected to two ends of the strip portion. The first surface of the strip portion and the edge of the bending region of the display surface of the flexible display are disposed facing each other. The fastening member is fastened to the hinge assembly, and the protruding portion of the fastening member and the middle part of the second surface of the strip portion are disposed facing each other, so as to prevent the flexible insert from being pried out under external force. In a process in which the foldable device switches between the unfolded state and the folded state, the first connecting portion and the second connecting portion are correspondingly embedded in the edge of the first main body and the edge of the second main body, so that the flexible insert moves synchronously with the first main body and the second main body. The middle part of the strip portion is limited by the protruding portion of the fastening member, and the strip portion may be bent around the protruding portion. When an included angle between the first main body and the second main body varies, the strip portion can keep covering the edge of the bending region of the display surface of the flexible display, to protect the edge of the bending region, thereby preventing external foreign objects such as dust and water from entering the flexible display, and improving aesthetics of a position of the edge of the bending region of the flexible display. Under prolonged repeated bending, static bending, or high-temperature and high-humidity conditions, deformation of the flexible insert is small, and the flexible insert is not prone to creasing, arching, or detachment, and can be restored to a flat natural form when being in an unfolded state, so that user experience is good, reliability is high, and a folding life is long. The flexible insert facilitates formation of a uniform bending form during bending of the flexible display, reduces mutual compression forces between the flexible insert and the flexible display in a folding process, and prevents the flexible display from sustaining crack damage due to compression.

When the foldable device is in the folded state, the middle part of the strip portion is limited by the protruding portion of the fastening member, and the strip portion can conform to the edge of the bending region on the bent display surface of the flexible display. When the cross section of the flexible display in the bent form is a water drop-shaped curved surface, a cross section of the strip portion is approximately a water drop-shaped curved surface, and the strip portion can effectively cover the edge of the bending region of the display surface of the flexible display.

In an optional implementation, the fastening member may be fastened to the hinge assembly through adhesive bonding, snap-fit connection, and a fastener (such as a screw), or in another manner. The fastening member may be disposed close to an end portion of the hinge assembly.

In an optional implementation, a material of the fastening member may be metal or plastic. The fastening member is made of hard materials such as metal and plastic, to facilitate reliably connecting the fastening member to the hinge assembly.

In an optional implementation, the fastening member may be approximately plate-shaped, and a thickness direction of the fastening member is the axial direction (Y direction) of the hinge assembly. Alternatively, the fastening member may be in a block shape or another shape.

In an optional implementation, the fastening member may include an insertion portion and an assembling portion, where the insertion portion is connected to the assembling portion. The insertion portion is configured to be inserted into the hinge assembly, and the assembling portion is configured to be connected to the supporting member. The insertion portion and the assembling portion are approximately T-shaped, to facilitate inserting the insertion portion into the hinge assembly, and two ends of the assembling portion abut against a surface of the hinge assembly, thereby limiting the fastening member.

In an optional implementation, the strip portion may be approximately set to be of a long strip structure. Both the elastic sheet and the strip portion in the flexible insert may extend along the edge of the bending region of the flexible display, so that the elastic sheet is closely connected to the strip portion, to shield and protect the edge of the bending region of the display surface. The strip portion may be of a long strip structure that is straight, partially curved, or with a specific radian.

In an optional implementation, the elastic sheet may be a plastic sheet or a metal sheet, a material of the flexible body may be soft adhesive, and the elastic sheet and the flexible body are of an insert molded structure. The flexible body is prone to injection molding, and the elastic sheet has specific rigidity and strength. The elastic sheet and the flexible body are combined to complement each other, and are connected stably, to form the integrated flexible insert. An overall thickness and a weight are small, and reliability is high.

In an optional implementation, the elastic sheet may be a plastic sheet, for example, a polyethylene terephthalate sheet or a polyimide sheet. The elastic sheet may alternatively be a metal sheet, for example, a steel sheet.

In an optional implementation, the material of the flexible body may be soft adhesive that is high-temperature-resistant and high-humidity-resistant, for example, silica gel, thermoplastic elastomer, thermoplastic urethane, polyvinyl chloride soft adhesive, rubber (such as silicone rubber, natural rubber, butadiene rubber, styrene-butadiene rubber, ethylene propylene rubber), or another material.

In an optional implementation, the elastic sheet is disposed on the first surface of the strip portion. The flexible insert with a small thickness may be obtained by using an integral forming process. For example, a thickness of the flexible insert is approximately 0.1 millimeters. This facilitates thinning of the entire foldable device. A part of the flexible body is used as an appearance surface, so that the flexible insert has good aesthetics.

In an optional implementation, the first surface of the strip portion has a first recess, and the elastic sheet is embedded in the first recess. The flexible body wraps a surface of the elastic sheet, thereby increasing a connection area between the flexible body and the elastic sheet. In this way, the flexible body and the elastic sheet are reliably connected.

In an optional implementation, the strip portion is provided with a first side edge facing the fastening member, the first connecting portion is disposed at one end of the first side edge, and the second connecting portion is disposed at the other end of the first side edge. The first connecting portion and the second connecting portion are offset from the side surface of the flexible display along the axial direction (Y direction) of the hinge assembly, so that the first connecting portion and the second connecting portion are correspondingly embedded in the first main body and the second main body.

In an optional implementation, a first sliding groove is provided at the edge that is of the first main body and that is adjacent to the hinge assembly, a length direction of the first sliding groove is the same as the length direction (X direction) of the strip portion, and the first connecting portion is slidably fitted in the first sliding groove. A second sliding groove is provided at the edge that is of the second main body and that is adjacent to the hinge assembly, a length direction of the second sliding groove is the same as the length direction (X direction) of the strip portion, and the second connecting portion is slidably fitted in the second sliding groove. In a process in which the foldable device switches between the unfolded state and the folded state, the first connecting portion is allowed to slide relative to the first main body, and the second connecting portion is allowed to slide relative to the second main body, so that the strip portion connected between the first connecting portion and the second connecting portion may form a uniform bending form.

In an optional implementation, a sliding stroke L of the first connecting portion in the first sliding groove ranges from 0.2 millimeter to 1 millimeter, and a sliding stroke L of the second connecting portion in the second sliding groove ranges from 0.2 millimeter to 1 millimeter, so that the first connecting portion and the second connecting portion at the two ends of the strip portion are correspondingly installed in the first sliding groove and the second sliding groove. This enables the strip portion to form a uniform bending form in a process in which the foldable device switches between the unfolded state and the folded state, thereby preventing the flexible insert from being detached from the first main body and the second main body.

In an optional implementation, the first connecting portion includes a first supporting portion and a first sliding portion. The first supporting portion is connected between the first side edge and the first sliding portion, one end that is of the first supporting portion and that is away from the first side edge is located in the first sliding groove, the first sliding portion is located in the first sliding groove, and cross-sectional shapes of the first sliding portion and the first sliding groove, taken perpendicular to the length direction of the strip portion, are adapted to each other.

This enables that the first sliding part may be offset by a specific distance along the thickness direction (Z direction) of the flexible display, and the first sliding portion may be slidably fitted on a first main body that is spaced apart from the display surface of the flexible display by a predetermined distance. The first sliding portion may slide steadily in a straight line along the length direction of the first sliding groove.

In an optional implementation, in the length direction (X direction) of the strip portion, an end surface that is of the first supporting portion and that is close to the fastening member and an end surface of the first sliding groove are disposed facing each other. A moving range of the first connecting portion is limited, preventing the first connecting portion from being detached from the first sliding groove.

In an optional implementation, the cross-sectional shapes of the first sliding portion and the first sliding groove, taken perpendicular to the length direction (X direction) of the strip portion, are each bent and extended. The first sliding portion is snapped onto the first sliding groove along the axial direction (Y direction) of the hinge assembly, so that the first sliding portion is not prone to detaching from the first main body along the axial direction (Y direction) of the hinge assembly, and the flexible insert is kept on the first main body.

In an optional implementation, cross-sectional shapes of the first sliding portion and the first sliding groove, taken perpendicular to the length direction (X direction) of the strip portion, are each bent extending shapes such as an L-shape and an arc shape, so that the first sliding portion can be snapped onto the first sliding groove along the axial direction (Y direction) of the hinge assembly without being prone to be detached.

In an optional implementation, the second connecting portion includes a second supporting portion and a second sliding portion. The second supporting portion is connected between the first side edge and the second sliding portion, one end that is of the second supporting portion and that is away from the first side edge is located in the second sliding groove, the second sliding portion is located in the second sliding groove, and cross-sectional shapes of the second sliding portion and the second sliding groove, taken perpendicular to the length direction (X direction) of the strip portion, are adapted to each other. This enables that the second sliding part may be offset by a specific distance along the thickness direction (Z direction) of the flexible display, and the second sliding portion may be slidably fitted on a second main body that is spaced apart from the display surface of the flexible display by a predetermined distance. The second sliding portion may slide steadily in a straight line along the length direction of the second sliding groove.

In an optional implementation, in the length direction (X direction) of the strip portion, an end surface that is of the second supporting portion and that is close to the fastening member and an end surface of the second sliding groove are disposed facing each other. The end surface of the second sliding groove abuts against the end surface of the second supporting portion, so that the second supporting portion cannot continue to move, limiting a moving range of the second connecting portion, and preventing the second connecting portion from being detached from the second sliding groove.

In an optional implementation, the cross-sectional shapes of the second sliding portion and the second sliding groove, taken perpendicular to the length direction (X direction) of the strip portion, are each bent and extended. The second sliding portion is not prone to detaching from the second main body along the axial direction (Y direction) of the hinge assembly, and the flexible insert is kept on the second main body.

In an optional implementation, cross-sectional shapes of the second sliding portion and the second sliding groove, taken perpendicular to the length direction of the strip portion, are each bent extending shapes such as an L-shape and an arc shape, thereby enabling the second sliding portion to be snapped onto the second sliding groove along the axial direction (Y direction) of the hinge assembly without being prone to be detached.

In an optional implementation, in the length direction (X direction) of the strip portion, the fastening member may be located between the first connecting portion and the second connecting portion, so that the strip portion between the first connecting portion and the second connecting portion may be shortened, thereby enabling the strip portion to cover the edge of the bending region of the display surface of the flexible display, to implement shielding and protection.

In an optional implementation, in the length direction (X direction) of the strip portion, the fastening member may be located between the first supporting portion in the first connecting portion and the second supporting portion in the second connecting portion, so that the thickness of the fastening member may be thinned, so that the fastening member is fastened to the end portion of the hinge assembly, and occupies small space of the hinge assembly.

In an optional implementation, in the thickness direction (Z direction) of the flexible display, the first connecting portion is located between the first side frame and the first main body, and the second connecting portion is located between the second side frame and the second main body, so that the strip portion and the elastic sheet between the first connecting portion and the second connecting portion are kept at a predetermined position and are not prone to detaching, and the flexible insert is reliably assembled between the first main body and the second main body.

In an optional implementation, a first limiting portion is connected to a side that is of the first side edge of the strip portion and that faces the flexible display, and the first limiting portion and the side surface of the flexible display are disposed facing each other. The first limiting portion abuts against a side surface of the flexible display under an external force, to prevent the flexible insert from being detached from the flexible display under an external force, so that the flexible insert is kept at a predetermined position, to shield and protect the edge of the bending region of the display surface of the flexible display, thereby improving reliability.

In an optional implementation, there is an avoidance groove on a side that is of the fastening member and that faces the flexible display, and the first limiting portion is at least partially embedded in the avoidance groove, so that the foldable device can be small in the axial direction (Y direction) of the hinge assembly. The first limiting portion and an inner wall of the avoidance groove are disposed facing each other. In a process in which the first main body and the second main body drive the strip portion to bend, the first limiting portion and the inner wall of the avoidance groove gradually approach each other to abut against each other, so that the bending form of the strip portion can be limited.

In an optional implementation, a safety gap is provided between the strip portion and the protruding portion, a second limiting portion is connected to the side of the middle part of the first side edge facing away from the flexible display, and in the thickness direction (Z direction) of the flexible display, the second limiting portion and the protruding portion are disposed facing each other.

When the foldable device is in the unfolded state, in the thickness direction (Z direction) of the flexible display, there is a predetermined safety gap between the protruding portion and the strip portion. A second limiting portion is disposed in a middle part of the first side edge of the strip portion. At a moment when the foldable device in the unfolded state is folded, the second limiting portion presses against the protruding portion, so that the middle part of the strip portion is not prone to be arched. Then, the strip portion and the elastic sheet are bent gradually, so that the flexible insert has a good bending form in a bending process. When the flexible insert is subjected to an external force, the second limiting portion may abut against the protruding portion of the fastening member, so as to prevent the flexible insert from being detached along the axial direction (Y direction) of the hinge assembly, and improve reliability.

In an optional implementation, there is an avoidance groove on a side that is of the fastening member and that faces the flexible display, and the second limiting portion is at least partially embedded in the avoidance groove, so that the foldable device can be small in the axial direction (Y direction) of the hinge assembly.

According to a second aspect, an embodiment of this application provides a foldable device, including a hinge assembly, a first main body, a second main body, a flexible display, and the edge protection assembly. The hinge assembly is located between the first main body and the second main body, and the first main body and the second main body are connected through the hinge assembly. The flexible display has a display surface and a back surface that face away from each other. The back surface of the flexible display is fastened to the first main body and the second main body.

In an optional implementation, one end of the first main body and one end of the second main body may rotate relative to the hinge assembly, and one end of the first main body away from the hinge assembly and one end of the second main body away from the hinge assembly may move close to or away from each other. The flexible display may be bent or unfolded as positions of the first main body and the second main body change, so that the foldable device switches between an unfolded state, an intermediate state, and a folded state.

In an optional implementation, the foldable device may be configured as being of an inwardly folding structure. When the hinge assembly is in the folded state, display accommodating space is formed between the first main body, the hinge assembly, and the second main body, the flexible display is partially bent, and the flexible display is located in the display accommodating space. A bending form of the flexible display is affected by the hinge assembly. When the hinge assembly is in the folded state, a cross section of the flexible display in the bent form may be a water drop-shaped curved surface or a U-shaped curved surface.

In an optional implementation, the flexible display has a first fastening region, a bending region, and a second fastening region that are sequentially connected. The first fastening region is fastened to the first main body, the second fastening region is fastened to the second main body, and the bending region and the hinge assembly are correspondingly disposed. The first fastening region and the first main body, and the second fastening region and the second main body may be connected through adhesive bonding or in another manner.

In an optional implementation, the hinge assembly may include a rotating shaft, a rotating shaft housing, a first plate body, and a second plate body. Both the rotating shaft and the rotating shaft housing extend in the Y direction. The rotating shaft is disposed close to the flexible display, and the rotating shaft housing is disposed on a side that is of the rotating shaft and that faces away from the flexible display. The first plate body and the second plate body are respectively connected to two sides of the rotating shaft in the X direction, and can rotate relative to the rotating shaft. The first plate body and the second plate body may be fastened to the first main body and the second main body in a one-to-one correspondence through a fastener or in another manner, so that the first main body and the second main body can rotate relative to the rotating shaft.

In an optional implementation, both the first main body and the second main body may include a middle housing and a rear housing. The middle housing may be referred to as a middle frame. The rear housing is disposed on a side that is of the middle housing and that faces away from the flexible display. The middle housing and the rear housing may be of an assembly structure. The middle housing and the rear housing may alternatively be of an integrally formed structure.

In an optional implementation, the first side frame is disposed on the first main body, and the first side frame is disposed on an edge that is of the flexible display and that corresponds to the first main body. The second side frame is disposed on the second main body, and the second side frame is disposed on an edge that is of the flexible display and that corresponds to the second main body. The first side frame may shield and protect an edge of the first fastening region of the flexible display, and the second side frame may shield and protect an edge of the second fastening region of the flexible display, to prevent the edge of the flexible display from being damaged and improve appearance effect.

In an optional implementation, the first main body and the first side frame may be of an assembly structure. For example, the first side frame is fastened to the first main body in a manner of bonding, snap-fitting, or the like. The first main body and the first side frame may alternatively be of an integrally formed structure. The second main body and the second side frame may be of an assembly structure. For example, the second side frame is fastened to the second main body in a manner of bonding, snap-fitting, or the like. The second main body and the second side frame may alternatively be of an integrally formed structure.

In an optional implementation, the flexible display in the unfolded state is approximately in a shape of a rounded rectangle, and the first main body and the second main body are approximately in a shape of a plate-shaped rectangle. Both the first side frame and the second side frame approximately extend in a right-angled U-shape, and cross-sectional shapes of the first side frame and the second side frame in a direction perpendicular to extension directions of the first side frame and the second side frame may be approximately L-shaped or in another shape. An opening of the first side frame and an opening of the second side frame are provided facing each other. The first side frame and the second side frame are respectively disposed corresponding to different edges of the flexible display, to implement shielding and protection at positions of corresponding edges of the flexible display.

In an optional implementation, one edge protection assembly may be disposed on each of two end portions of the hinge assembly, to shield and protect edges, of the bending region of the flexible display, corresponding to the two end portions of the hinge assembly.

In an optional implementation, in a thickness direction (Z direction) of the flexible display, a first gap is formed between the first side frame and the display surface of the flexible display, and a second gap is formed between the second side frame and the display surface of the flexible display. One end of a strip portion is located in the first gap, and the other end of the strip portion is located in the second gap, thereby realizing positional limitation for both ends of the strip portion.

In an optional implementation, in the axial direction (Y direction) of the hinge assembly, a third gap is formed between the first side frame and a side surface of the flexible display, and a fourth gap is formed between the second side frame and the side surface of the flexible display. A part of the first connecting portion (that is, the first supporting portion in the first connecting portion) is located in the third gap, and a part of the second connecting portion (that is, the second supporting portion in the second connecting portion) is located in the fourth gap. In this way, the two ends of the flexible insert move along with the first main body and the second main body, and the flexible insert is kept at the edge of the flexible display, and is not prone to be detached, to reliably shield and protect the edge of the flexible display, and prevent the flexible insert from being detached under action of an external force.

In an optional implementation, there is a first shielding portion at a position that is of the first side frame and that is close to the hinge assembly, and there is a second shielding portion at a position that is of the second side frame and that is close to the hinge assembly. In the axial direction (Y direction) of the hinge assembly, a projection of the first shielding portion partially covers a fastening member, and a projection of the second shielding portion partially covers the fastening member. This protects the fastening member, prevents an external foreign object, such as a particle, from entering a gap between the fastening member and the hinge assembly, improves reliability, and improves an appearance of the end portion of the hinge assembly.

### BRIEF DESCRIPTION OF DRAWINGS

FIG. 1 is a diagram of fitting between an edge protection assembly and a flexible display in a foldable device according to an embodiment of this application;
FIG. 2 is a diagram of a structure of a foldable device in an unfolded state according to an embodiment of this application;
FIG. 3 is a diagram of a structure of the foldable device in FIG. 2 in a folded state;
FIG. 4 is a three-dimensional exploded view of the foldable device in FIG. 2;
FIG. 5 is a diagram of a structure of the foldable device in FIG. 2 from which a first side frame is detached;
FIG. 6 is a diagram of structures of a display, an edge protection assembly, and a hinge assembly in the foldable device in FIG. 4;
FIG. 7 is a diagram of assembly of the display, the edge protection assembly, and the hinge assembly in FIG. 6;
FIG. 8 is a three-dimensional diagram of assembly of an edge protection assembly according to an embodiment of this application;
FIG. 9 is a three-dimensional diagram of assembly of the edge protection assembly in FIG. 8 from another angle;
FIG. 10 is a three-dimensional exploded view of the edge protection assembly in FIG. 8;
FIG. 11 is a partial sectional view of the foldable device in FIG. 2 along a line A-A;
FIG. 12 is a partial sectional view of the foldable device in FIG. 2 along a line B-B;
FIG. 13 is an exploded diagram of an edge protection assembly, a first main body, and a second main body in the foldable device in FIG. 4;
FIG. 14 is a diagram of assembly of the edge protection assembly in FIG. 13 disposed between the first main body and the second main body;
FIG. 15 is a three-dimensional diagram of assembly of the edge protection assembly in FIG. 8 from another angle;
FIG. 16 is a three-dimensional exploded view of the edge protection assembly in FIG. 15; and
FIG. 17 is a three-dimensional sectional view of the edge protection assembly in FIG. 8 along a line C-C.

### Description of reference numerals:

1: shielding member; 1a: soft adhesive; 1b: steel sheet; 2: flexible display;
1000: foldable device; 100: edge protection assembly;
110: fastening member; 111: protruding portion; 112: insertion portion; 113: assembling portion; 114: avoidance groove;
120: flexible insert; 121: elastic sheet; 122: flexible body; 1221: strip portion; 1221a: end; 1221b: end; 1221c: first surface; 1221d: first recess; 1221e: second surface; 1221f: middle part; 1221g: first side edge; 1221h: middle part; 1222: first connecting portion; 1222a: first supporting portion; 1222b: end surface; 1222c: first sliding portion; 1223: second connecting portion; 1223a: second supporting portion; 1223b: end surface; 1223c: second sliding portion; 1224: first limiting portion; 1225: second limiting portion;
200: hinge assembly; 200a: end portion; 210: rotating shaft; 220: rotating shaft housing; 230: first plate body; 240: second plate body;
300: flexible display; 300a: display surface; 300b: back surface; 300c: side surface; 301: first fastening region; 302: bending region; 303: second fastening region;
400: first main body; 400a: edge; 401: first sliding groove; 401a: end surface; 410: middle housing; 420: rear housing;
500: second main body; 500a: edge; 501: second sliding groove; 501a: end surface;
600: first side frame; 601: opening; 602: first blocking portion; 611: first gap; 612: second gap; 613: third gap;
700: second side frame; 701: opening; and 702: second blocking portion.

### DESCRIPTION OF EMBODIMENTS

To make technical problems to be resolved, technical solutions, and beneficial effects of this application clearer, the following further describes this application in detail with reference to accompanying drawings and embodiments. It should be understood that the specific embodiments described herein are merely used to explain this application but are not intended to limit this application. Although this application is described with reference to some embodiments, this does not mean that features of this application are limited only to the implementations. On the contrary, a purpose of describing this application with reference to an implementation is to cover another option or modification that may be derived based on claims of this application. To provide an in-depth understanding of this application, the following descriptions include a plurality of specific details. This application may be alternatively implemented without using these details. In addition, to avoid confusion or blurring a focus of this application, some specific details are omitted from the description. It should be noted that embodiments in this application and the features in embodiments may be mutually combined in the case of no conflict.

It should be noted that when an element is referred to as "fastened to" or "disposed on" another element, the element may be directly or indirectly on the another element. When an element is referred to as "connected to" another element, the element may be directly or indirectly connected to the another element.

It should be understood that in descriptions of embodiments of this application, it should be noted that, unless otherwise clearly specified and limited, terms "mount" and "connection" should be understood in a broad sense. For example, "connection" may be a detachable connection, a nondetachable connection, a direct connection, or an indirect connection through an intermediate medium. Orientation or position relationships indicated by terms "length", "width", "upper", "lower", "front", "rear", "left", "right", "vertical", "horizontal", "top", "bottom", "inner", "outer", and the like are orientation or position relationships based on the accompanying drawings. This is merely intended to facilitate and simplify the descriptions of this application, but is not intended to indicate or imply that an indicated apparatus or element needs to have a specific orientation or be constructed and operated in a specific orientation. Therefore, such terms cannot be construed as a limitation on this application.

In addition, the terms "first" and "second" are merely intended for a purpose of description, and shall not be understood as an indication or implication of relative importance or implicit indication of the number of indicated technical features. Therefore, a feature limited by "first" or "second" may explicitly or implicitly include one or more features. In the descriptions of this application, "a plurality of" means two or more, unless otherwise explicitly and specifically defined.

The term "and/or" in embodiments of this application describes only an association relationship for describing associated objects and represents that three relationships may exist. For example, A and/or B may represent the following three cases: Only A exists, both A and B exist, and only B exists. In addition, the character "/" in this specification generally indicates an "or" relationship between the associated objects.

Reference to "an embodiment", "some embodiments", or the like described in this specification indicates that one or more embodiments of this application include a specific feature, structure, or characteristic described with reference to embodiments. Therefore, statements such as "in an embodiment", "in some embodiments", "in some other embodiments", and "in other embodiments" that appear at different places in this specification do not necessarily mean referring to a same embodiment. Instead, the statements mean "one or more but not all of embodiments", unless otherwise specifically emphasized in another manner. The terms "include", "have", and their variants all mean "include but are not limited to", unless otherwise specifically emphasized in another manner.

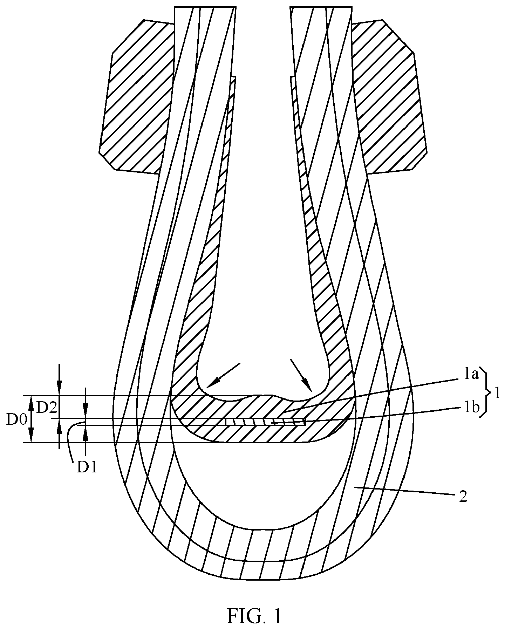

Refer to FIG. 1. An embodiment of this application provides an edge protection assembly, which may be applied to a foldable device. The edge protection assembly has a shielding member 1, and the shielding member 1 can shield and protect an edge of a bending region of a flexible display 2. The shielding member 1 may use an integrated injection-molded structure in which soft adhesive 1a wraps a steel sheet 1b, and the soft adhesive 1a is disposed on both an upper side and a lower side of the steel sheet 1b.

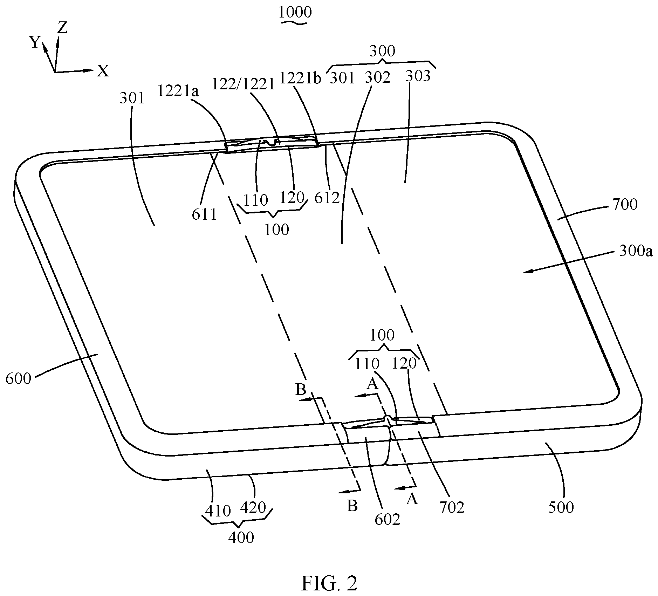

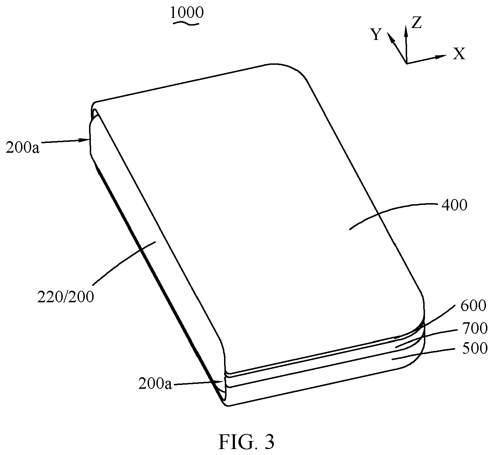

Refer to FIG. 2 and FIG. 3. To facilitate description of positions and directions of a foldable device 1000 and an edge protection assembly 100 in embodiments of this application, an arrangement direction of a first main body 400 and a second main body 500 of the foldable device 1000 in an unfolded state is defined as an X direction, a width direction of the foldable device 1000 or an axial direction of a hinge assembly 200 is defined as a Y direction, a thickness direction of the foldable device 1000 is defined as a Z direction, a thickness direction of a flexible display 300 in an unfolded state is also defined as the Z direction, and the X direction, the Y direction, and the Z direction are perpendicular to each other.

Refer to FIG. 2 and FIG. 3. An embodiment of this application provides the foldable device 1000, which may be a mobile phone, a tablet computer, a notebook computer, an e-book reader, a netbook, a personal digital assistant, an intelligent wearable device (such as a smartwatch), or the like.

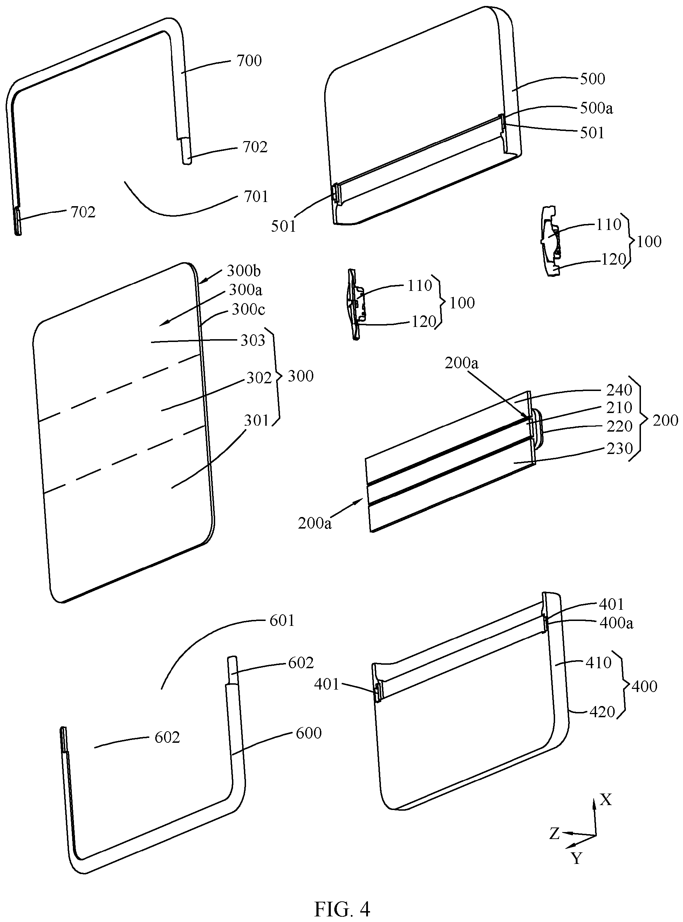

With reference to FIG. 4, an embodiment of this application provides the foldable device 1000, including the hinge assembly 200, the first main body 400, the second main body 500, the flexible display 300, and the edge protection assembly 100. The hinge assembly 200 is located between the first main body 400 and the second main body 500, and the first main body 400 and the second main body 500 are connected through the hinge assembly 200. The flexible display 300 has a display surface 300a and a back surface 300b that face away from each other. The back surface 300b of the flexible display 300 is fastened to the first main body 400 and the second main body 500.

One end of the first main body 400 and one end of the second main body 500 may rotate relative to the hinge assembly 200, and one end that is of the first main body 400 and that faces away from the hinge assembly 200 and one end that is of the second main body 500 and that faces away from the hinge assembly 200 may move toward or away from each other. The flexible display 300 may be bent or unfolded as positions of the first main body 400 and the second main body 500 change, so that the foldable device 1000 switches between an unfolded state, an intermediate state, and a folded state.

Refer to FIG. 2. When the foldable device 1000 is in the unfolded state, the first main body 400 and the second main body 500 are respectively arranged on two sides of the hinge assembly 200 and are unfolded, an included angle between the first main body 400 and the second main body 500 is approximately 180°, and the flexible display 300 is unfolded and supported on the first main body 400, the hinge assembly 200, and the second main body 500.

Refer to FIG. 3. When the foldable device 1000 is in the folded state, the first main body 400 and the second main body 500 are folded to form a stacked structure, and the flexible display 300 is bent along with the first main body 400 and the second main body 500. The intermediate state of the foldable device 1000 is a state between the unfolded state and the folded state.

The foldable device 1000 may be configured as being of an inwardly folding structure. When the hinge assembly 200 is in the folded state, display accommodating space is formed between the first main body 400, the hinge assembly 200, and the second main body 500, the flexible display 300 is partially bent, and the flexible display 300 is located in the display accommodating space. A bent form of the flexible display 300 is affected by the hinge assembly 200. When the hinge assembly 200 is in the folded state, a cross section of the flexible display 300 in the bent form may be a water drop-shaped curved surface or a U-shaped curved surface.

The flexible display 300 is configured to display an image and information. The flexible display 300 may be an organic light-emitting diode display, an active-matrix organic light-emitting diode display, a mini light-emitting diode display, a micro light-emitting diode display, a micro organic light-emitting diode display, a quantum dot light-emitting diode display, or the like. A touch layer may be disposed in the flexible display 300 to implement a touch function.

Refer to FIG. 2 and FIG. 4. The flexible display 300 has a first fastening region 301, a bending region 302, and a second fastening region 303 that are sequentially connected. The first fastening region 301 is fastened to the first main body 400, the second fastening region 303 is fastened to the second main body 500, and the bending region 302 and the hinge assembly 200 are correspondingly disposed. The first fastening region 301 and the first main body 400, and the second fastening region 303 and the second main body 500 may be connected through adhesive bonding or in another manner.

During disposing of the hinge assembly 200, as shown in FIG. 4, the hinge assembly 200 may include a rotating shaft 210, a rotating shaft housing 220, a first plate body 230, and a second plate body 240. Both the rotating shaft 210 and the rotating shaft housing 220 extend in the Y direction. The rotating shaft 210 is disposed close to the flexible display 300, and the rotating shaft housing 220 is disposed on a side that is of the rotating shaft 210 and that faces away from the flexible display 300. The first plate body 230 and the second plate body 240 are respectively connected to two sides of the rotating shaft 210 in the X direction, and can rotate relative to the rotating shaft 210. The first plate body 230 and the second plate body 240 may be fastened to the first main body 400 and the second main body 500 in a one-to-one correspondence through a fastener or in another manner, so that the first main body 400 and the second main body 500 can rotate relative to the rotating shaft 210.

During disposing of the first main body 400 and the second main body 500, as shown in FIG. 2, both the first main body 400 and the second main body 500 may include a middle housing 410 and a rear housing 420. The middle housing 410 may be referred to as a middle frame. The rear housing 420 is disposed on a side that is of the middle housing 410 and that faces away from the flexible display 300. The middle housing 410 and the rear housing 420 may be of an assembly structure, for example, the rear housing 420 is fastened to the middle housing 410 in a manner of bonding, snap-fitting, or the like. The middle housing 410 and the rear housing 420 may alternatively be of an integrally formed structure. Components such as a circuit board, a battery, a receiver, a speaker, a camera, and an antenna may be installed on the first main body 400 and the second main body 500. Components such as a processor and a storage unit may be disposed on the circuit board.

In some embodiments, as shown in FIG. 2, FIG. 4, and FIG. 5, a first side frame 600 is disposed on the first main body 400, and the first side frame 600 is disposed on an edge 400a that is of the flexible display 300 and that corresponds to the first main body 400, to shield and protect the edge of the flexible display 300. A second side frame 700 is disposed on the second main body 500, and the second side frame 700 is disposed on an edge 500a that is of the flexible display 300 and that corresponds to the second main body 500. The first side frame 600 may shield and protect an edge of the first fastening region 301 of the flexible display 300, and the second side frame 700 may shield and protect an edge of the second fastening region 303 of the flexible display 300, to prevent the edge of the flexible display 300 from being damaged and improve appearance effect.

The first main body 400 and the first side frame 600 may be of an assembly structure. For example, the first side frame 600 is fastened to the first main body 400 in a manner of bonding, snap-fitting, or the like. The first main body 400 and the first side frame 600 may alternatively be of an integrally formed structure. The second main body 500 and the second side frame 700 may be of an assembly structure. For example, the second side frame 700 is fastened to the second main body 500 in a manner of bonding, snap-fitting, or the like. The second main body 500 and the second side frame 700 may alternatively be of an integrally formed structure.

Forms of the first main body 400 and the second main body 500, and forms of the first side frame 600 and the second side frame 700 may be set based on a shape of the flexible display 300. For example, as shown in FIG. 4, the flexible display 300 in the unfolded state is approximately in a shape of a rounded rectangle, and the first main body 400 and the second main body 500 are approximately in a shape of a plate-shaped rectangle. Both the first side frame 600 and the second side frame 700 approximately extend in a right-angled U-shape, and cross-sectional shapes of the first side frame 600 and the second side frame 700 in a direction perpendicular to extension directions of the first side frame 600 and the second side frame 700 may be approximately L-shaped or in another shape. An opening 601 of the first side frame 600 and an opening 701 of the second side frame 700 are provided facing each other. The first side frame 600 and the second side frame 700 are respectively disposed corresponding to different edges of the flexible display 300, to implement shielding and protection at positions of corresponding edges of the flexible display 300. In addition, the first main body 400 and the second main body 500, and the first side frame 600 and the second side frame 700 may be disposed in other forms based on the flexible display 300.

Refer to FIG. 2 and FIG. 5 to FIG. 7. An edge of the bending region 302 of the flexible display 300 is bent. The edge protection assembly 100 may be disposed between the first side frame 600 and the second side frame 700, that is, may be disposed between the first main body 400 and the second main body 500, to shield and protect the edge of the bending region 302 of the flexible display 300, thereby preventing external foreign objects such as dust and water from entering the flexible display 300, and improving aesthetics of a position of the edge of the bending region 302 of the flexible display 300. One edge protection assembly 100 may be disposed on each of two end portions 200a of the hinge assembly 200, to shield and protect edges, of the bending region 302 of the flexible display 300, corresponding to the two end portions 200a of the hinge assembly 200.

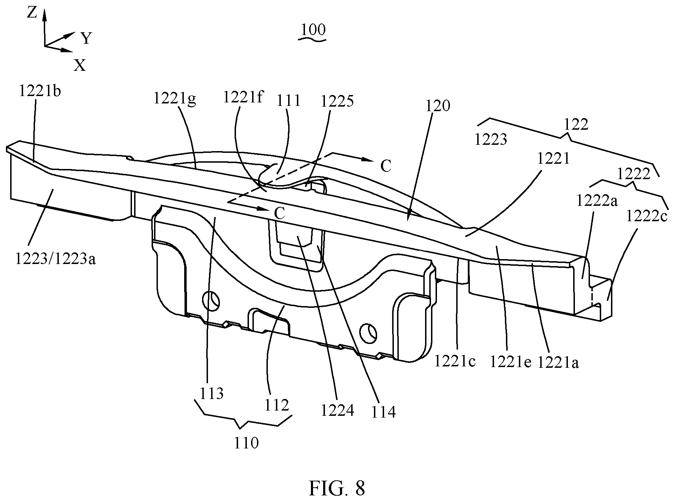

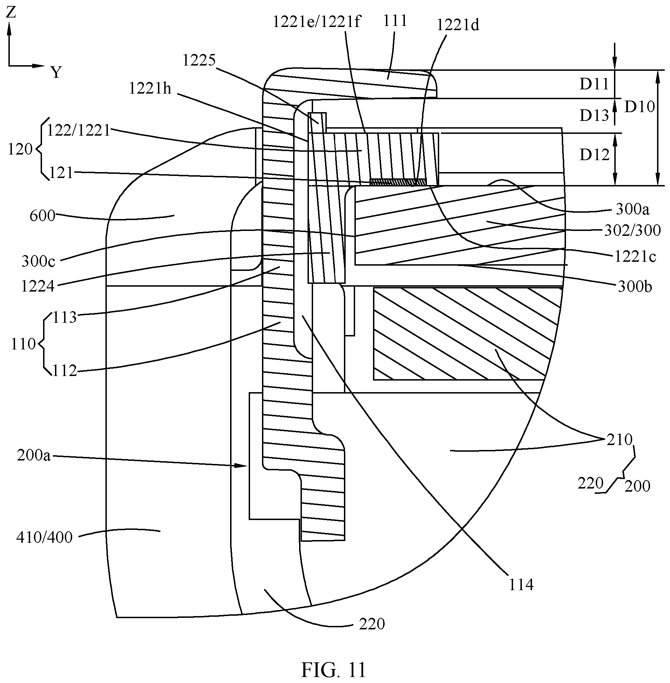

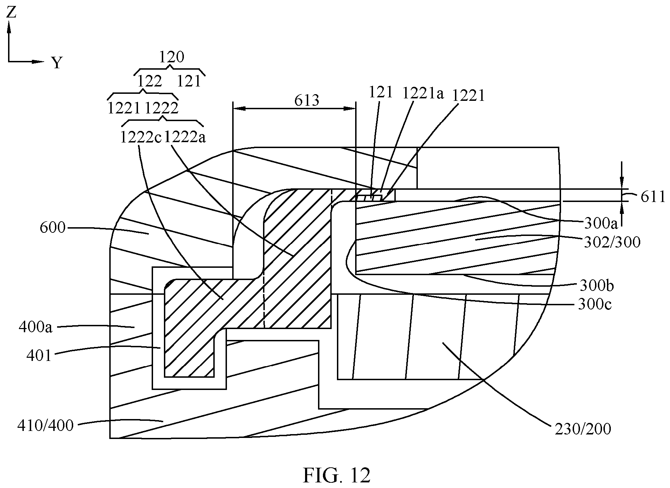

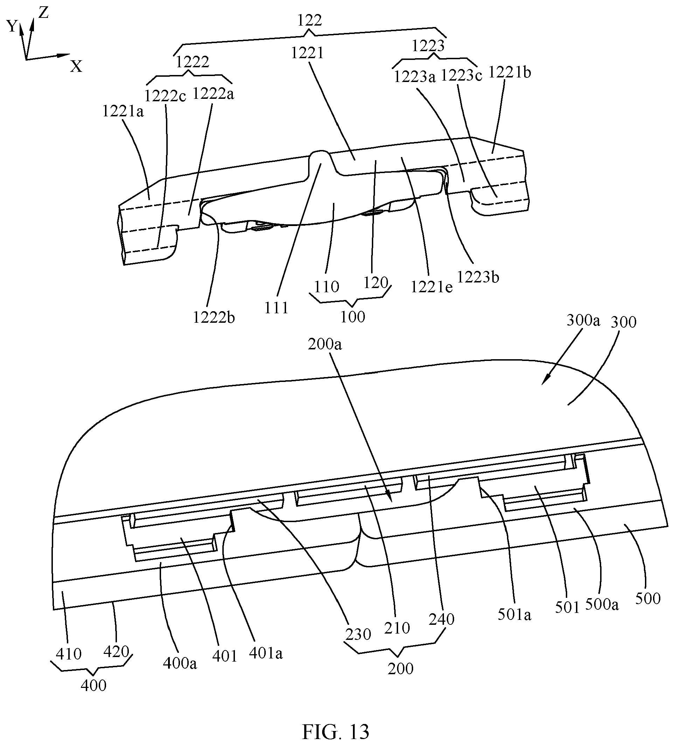

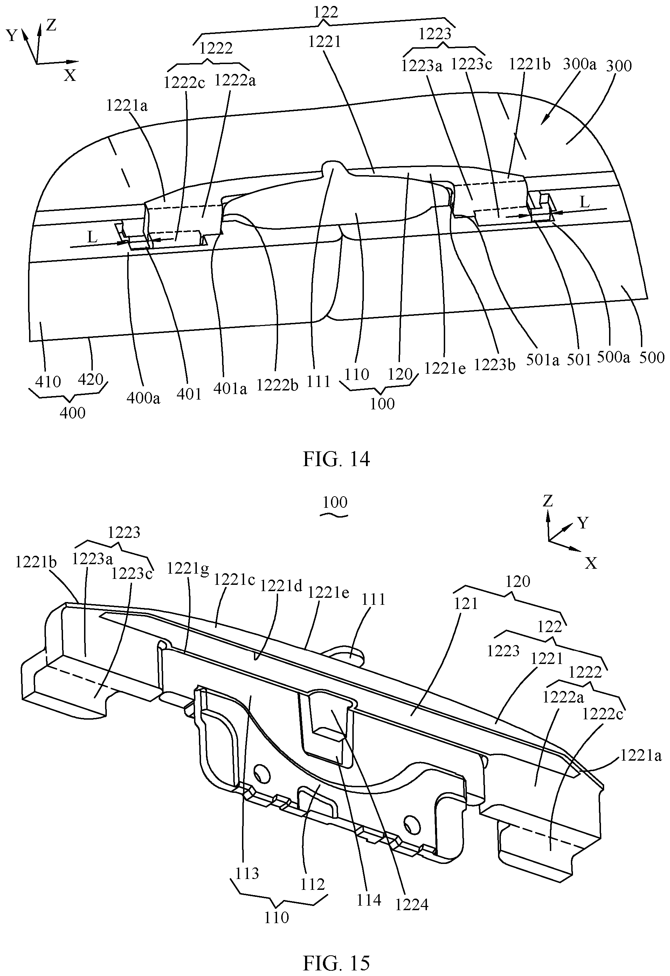

Refer to FIG. 8 to FIG. 11. FIG. 11 is a partial cross-sectional view of the foldable device 1000 of FIG. 2 along a line A-A. The edge protection assembly 100 provided in embodiments of this application is applied to the foldable device 1000 having the hinge assembly 200, the first main body 400, the second main body 500, and the flexible display 300. The edge protection assembly 100 includes a fastening member 110 and a flexible insert 120, and the fastening member 110 is configured to be fastened to the hinge assembly 200. In an axial direction (Y direction) of the hinge assembly 200, a projection of the fastening member 110 covers a part of a side surface 300c of the flexible display 300. The fastening member 110 has a protruding portion 111. The flexible insert 120 includes an elastic sheet 121 and a flexible body 122, and the elastic sheet 121 and the flexible body 122 are of an integrally formed structure. The flexible body 122 includes a strip portion 1221, a first connecting portion 1222, and a second connecting portion 1223. The first connecting portion 1222 is connected to one end 1221a of the strip portion 1221, the second connecting portion 1223 is connected to the other end 1221b of the strip portion 1221, and the elastic sheet 121 is embedded within the strip portion 1221. The strip portion 1221 has a first surface 1221c and a second surface 1221e that face away from each other, the first surface 1221c and the edge of the bending region 302 of the display surface 300a of the flexible display 300 are disposed facing each other, and the protruding portion 111 and the second surface 1221e are disposed facing each other at a middle part 1221f of the strip portion 1221 in a length direction thereof. With reference to FIG. 12 to FIG. 14, FIG. 12 is a partial cross-sectional view of the foldable device 1000 of FIG. 2 along a line B-B. FIG. 13 is an exploded diagram of the edge protection assembly, the first main body, and the second main body. FIG. 14 is a diagram of assembly of the edge protection assembly 100 disposed between the first main body and the second main body. The first connecting portion 1222 is configured to be embedded in an edge 400a of the first main body 400, and the second connecting portion 1223 is configured to be embedded in an edge 500a of the second main body 500.

Refer to FIG. 4, FIG. 6, and FIG. 11. The side surface 300c of the flexible display 300 is an outer circumferential surface connecting the display surface 300a and the back surface 300b. The display surface 300a of the flexible display 300 is a light-emitting side of the flexible display 300, and the display surface 300a may include a display region and a non-display region located at an edge of the display region. In the thickness direction (Z direction) of the flexible display 300, the flexible insert 120 may block a part of an edge of the non-display region, and does not affect light-emitting display effect of the display region of the flexible display 300.

The length direction (X direction) of the strip portion 1221 is a length direction of the strip portion 1221 when the foldable device 1000 is in the unfolded state. The length direction (X direction) of the strip portion 1221 is perpendicular to the axial direction (Y direction) of the hinge assembly 200. The middle part 1221f of the second surface 1221e in the length direction (X direction) of the strip portion 1221 may not be an exact middle position in the length direction, but a middle region of the second surface 1221e in the length direction of the strip portion 1221. Positions other than two ends (1221a, 1221b) in the length direction of the strip portion 1221 may be understood as the middle part 1221f in the length direction.

The edge 400a of the first main body 400 is an edge position of a side that is of the first main body 400 and that is configured to be connected to the flexible display 300. The edge 500a of the second main body 500 is an edge position of a side that is of the second main body 500 and that is configured to be connected to the flexible display 300.

According to the edge protection assembly 100 provided in this embodiment of this application, the flexible insert 120 is of an integrally formed structure of the elastic sheet 121 and the flexible body 122, the flexible body 122 is prone to bending and deformation, and the elastic sheet 121 plays a reinforcement role. The elastic sheet 121 is embedded within the strip portion 1221 of the flexible body 122, and the first connecting portion 1222 and the second connecting portion 1223 are correspondingly connected to the two ends (1221a, 1221b) of the strip portion 1221. The first surface 1221c of the strip portion 1221 and the edge of the bending region 302 of the display surface 300a of the flexible display 300 are disposed facing each other. The fastening member 110 is fastened to the hinge assembly 200, and the protruding portion 111 of the fastening member 110 and the middle part 1221f of the second surface 1221e of the strip portion 1221 are disposed facing each other, so as to prevent the flexible insert 120 from being pried out under external force. In a process in which the foldable device 1000 switches between the unfolded state and the folded state, the first connecting portion 1222 and the second connecting portion 1223 are correspondingly embedded within the edge 400a of the first main body 400 and the edge 500a of the second main body 500, so that the flexible insert 120 moves synchronously with the first main body 400 and the second main body 500. The middle part 1221f of the strip portion 1221 is limited by the protruding portion 111 of the fastening member 110, and the strip portion 1221 may be bent around the protruding portion 111. When an included angle between the first main body 400 and the second main body 500 varies, the strip portion 1221 can keep covering the edge of the bending region 302 of the display surface 300a of the flexible display 300, to protect the edge of the bending region 302, thereby preventing external foreign objects such as dust and water from entering the flexible display 300, and improving aesthetics of a position of the edge of the bending region 302 of the flexible display 300. Under prolonged repeated bending, static bending, or high-temperature and high-humidity conditions, deformation of the flexible insert 120 is small, and the flexible insert is not prone to creasing, arching, or detachment, and can be restored to a flat natural form when being in an unfolded state, so that user experience is good, reliability is high, and a folding life is long. The flexible insert 120 facilitates formation of a uniform bending form during bending of the flexible display 300, reduces mutual compression forces between the flexible insert 120 and the flexible display 300 in a folding process, and prevents the flexible display 300 from sustaining crack damage due to compression. Even if a bending radius of the flexible display 300 reaches 1.5 millimeters, the flexible display 300 is still not prone to crack damage due to compression from the flexible insert 120.

When the foldable device 1000 is in the folded state, the middle part 1221f of the strip portion 1221 is limited by the protruding portion 111 of the fastening member 110, and the strip portion 1221 can conform to the edge of the bending region 302 on the bent display surface 300a of the flexible display 300. When the cross section of the flexible display 300 in the bent form is a water drop-shaped curved surface, a cross section of the strip portion 1221 is approximately a water drop-shaped curved surface, and the strip portion 1221 can effectively cover the edge of the bending region 302 of the display surface 300a of the flexible display 300.

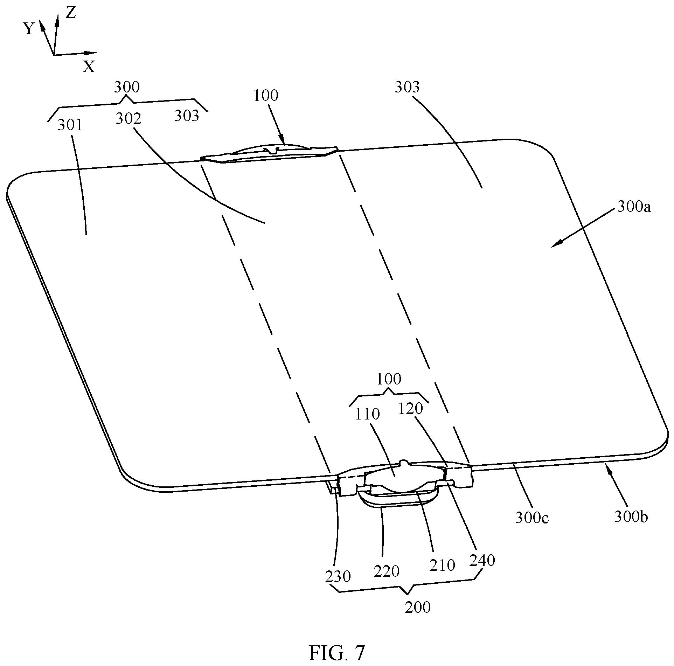

When the fastening member 110 is fastened to the hinge assembly 200, as shown in FIG. 7 and FIG. 11, the fastening member 110 may be fastened to the hinge assembly 200 through adhesive bonding, snap-fit connection, and a fastener (such as a screw), or in another manner. The fastening member 110 may be disposed close to the end portion 200a of the hinge assembly 200.

During setting of a material of the fastening member 110, as shown in FIG. 8 to FIG. 10, the material of the fastening member 110 may be metal or plastic. The fastening member 110 is made of hard materials such as metal and plastic, to facilitate reliably connecting the fastening member 110 to the hinge assembly 200.

When the fastening member 110 is made of a metal material, the fastening member 110 has high strength, and can achieve good anti-collision effect. The metal material may be stainless steel, cast iron, aluminum alloy, magnesium alloy, or the like.

For example, the fastening member 110 may be manufactured by using a metal injection process, have high dimensional precision and good structural strength, and can provide good protection effect for the edge of the flexible display 300. Alternatively, the fastening member 110 may be manufactured by using a process such as die casting molding.

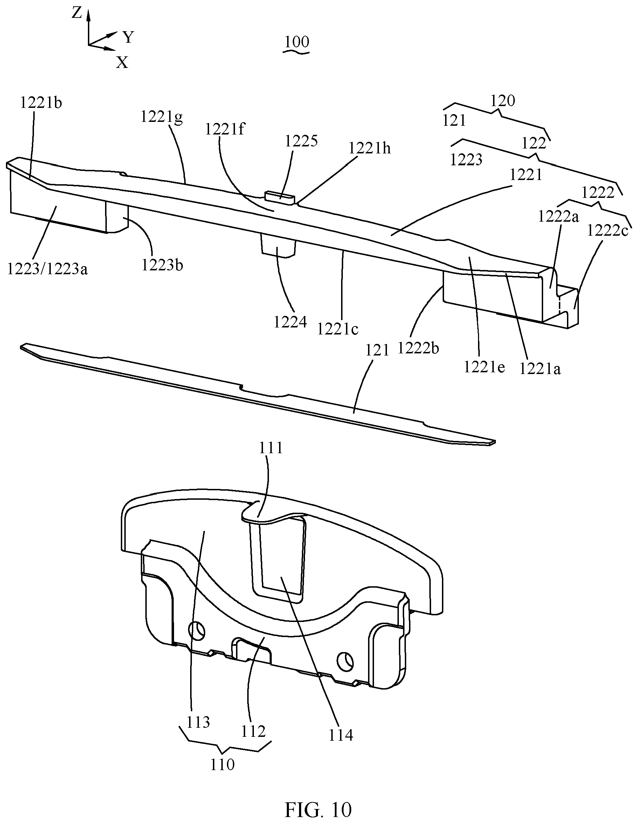

Refer to FIG. 10. The shape of the fastening member 110 may be set according to a requirement based on an appearance and a size of the flexible display 300 and an appearance and a size of the hinge assembly 200. For example, the fastening member 110 may be approximately plate-shaped, and a thickness direction of the fastening member 110 is the axial direction (Y direction) of the hinge assembly 200. Alternatively, the fastening member 110 may be in a block shape or another shape.

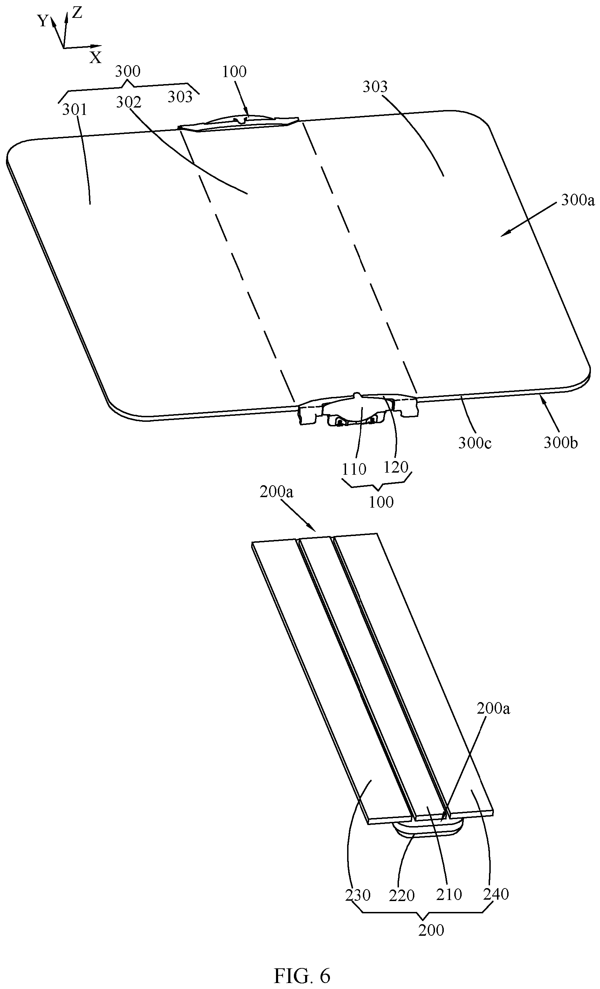

For example, as shown in FIG. 8 to FIG. 11, the fastening member 110 may include an insertion portion 112 and an assembling portion 113, where the insertion portion 112 is connected to the assembling portion 113. With reference to FIG. 6 and FIG. 7, the insertion portion 112 is configured to be inserted into the hinge assembly 200, and the assembling portion 113 is configured to be connected to the supporting member. A length of the insertion portion 112 in the X direction is less than a length of the assembling portion 113 in the X direction, the insertion portion 112 and the assembling portion 113 are approximately T-shaped, to facilitate inserting the insertion portion 112 into the hinge assembly 200, and two ends of the assembling portion 113 abut against a surface of the hinge assembly 200, thereby limiting the fastening member 110.

A shape of the strip portion 1221 may be set according to a requirement based on an appearance and a size of the flexible display 300. For example, as shown in FIG. 8 to FIG. 10, the strip portion 1221 may be approximately set to be of a long strip structure. Both the elastic sheet 121 and the strip portion 1221 in the flexible insert 120 may extend along the edge of the bending region 302 of the flexible display 300, so that the elastic sheet 121 is closely connected to the strip portion 1221, to shield and protect the edge of the bending region 302 of the display surface 300a. The strip portion 1221 may be of a long strip structure that is straight, partially curved, or with a specific radian. In addition, the elastic sheet 121 and the strip portion 1221 may alternatively be set to be in other shapes.

During manufacturing of the elastic sheet 121 and the flexible body 122, as shown in FIG. 8 to FIG. 10, the elastic sheet 121 may be a plastic sheet or a metal sheet, a material of the flexible body 122 may be soft adhesive, and the elastic sheet 121 and the flexible body 122 are of an insert molded structure.

The elastic sheet 121 and the flexible body 122 are of an insert molded structure. Insert molding is to fasten an insert to a predetermined position in a mold in advance, and then inject plastic for molding. After the mold is opened, the insert is wrapped in cooled and cured plastic in a product. The flexible body 122 is prone to injection molding, and the elastic sheet 121 has specific rigidity and strength. The elastic sheet 121 is used as the insert, and injection molding is performed to obtain the flexible body 122 that wraps the elastic sheet 121. The elastic sheet 121 and the flexible body 122 are combined to complement each other, and are connected stably, to form the integrated flexible insert 120. In this way, an overall thickness and a weight are small, reliability is high, and the flexible insert 120 is not prone to creasing, arching, and detachment upon prolonged repeated bending and use in high-temperature and high-humidity conditions.

The elastic sheet 121 may be a plastic sheet, for example, a polyethylene terephthalate (polyethylene terephthalate, PET) sheet or a polyimide (polyimide, PI) sheet. The elastic sheet 121 may alternatively be a metal sheet, for example, a steel sheet.

The material of the flexible body 122 may be soft adhesive that is high-temperature-resistant and high-humidity-resistant, for example, silica gel, thermoplastic elastomer (thermoplastic elastomer, TPE), thermoplastic urethane (thermoplastic urethane, TPU), polyvinyl chloride (polyvinyl chloride, PVC) soft adhesive, rubber (such as silicone rubber, natural rubber, butadiene rubber, styrene-butadiene rubber, ethylene propylene rubber), or another material.

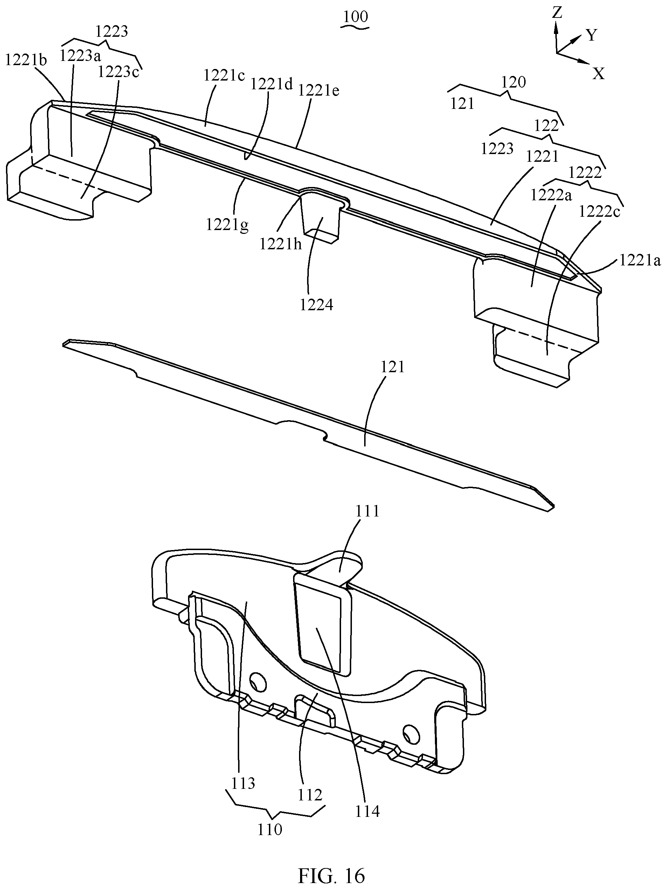

When relative positions of the elastic sheet 121 and the strip portion 1221 are set, as shown in FIG. 11, FIG. 15 and FIG. 16, the elastic sheet 121 is disposed on the first surface 1221c of the strip portion 1221. In the thickness direction (Z direction) of the flexible display 300, the strip portion 1221 covers the elastic sheet 121, and the elastic sheet 121 and the edge of the bending region 302 of the display surface 300a of the flexible display 300 are disposed facing each other. The flexible insert 120 with a small thickness may be obtained by using an integral forming process. For example, a thickness of the flexible insert 120 is approximately 0.1 millimeters. This facilitates thinning of the entire foldable device 1000. A part of the flexible body 122 is used as an appearance surface, and a top of the flexible body 122 can be seen from the outside, but the elastic sheet 121 cannot be seen, so that the flexible insert 120 has good aesthetics.

To achieve a tight connection between the elastic sheet 121 and the strip portion 1221, in some embodiments, as shown in FIG. 11, FIG. 15 and FIG. 16, there is a first recess 1221d on the first surface 1221c of the strip portion 1221, and the elastic sheet 121 is embedded in the first recess 1221d. The elastic sheet 121 is embedded in the first recess 1221d, so that the flexible body 122 is used as an appearance member, and the flexible body 122 wraps a surface of the elastic sheet 121, thereby increasing a connection area between the flexible body 122 and the elastic sheet 121. In this way, the flexible body 122 and the elastic sheet 121 are reliably connected.

In the embodiment shown in FIG. 1, the shielding member 1 uses an integrated injection-molded structure in which the soft adhesive 1a wraps the steel sheet 1b, the soft adhesive 1a is disposed on both the upper side and the lower side of the steel sheet 1b, and a total thickness D0 of the shielding member 1 is a sum of twice a thickness D2 of one layer of soft adhesive 1a and a thickness D1 of one layer of steel sheet 1b. The thickness D2 of one layer of soft adhesive 1a manufactured by using a related process is much greater than the thickness D1 of one layer of steel sheet 1b (or plastic sheet), so that the overall thickness D0 of the shielding member 1 shown in FIG. 1 is large.

In embodiments shown in FIG. 8 to FIG. 11, the protruding portion 111 of the fastening member 110 may be a sheet-like body made of metal or plastic. A thickness D11 of the protruding portion 111 in embodiments shown in FIG. 8 to FIG. 11 may be equivalent to the thickness D1 of one layer of steel sheet in the shielding member shown in FIG. 1, and a total thickness D12 of the strip portion 1221 and the elastic sheet 121 in the flexible body 122 in embodiments shown in FIG. 8 to FIG. 11 may be equivalent to the thickness D2 of one layer of soft adhesive in the shielding member shown in FIG. 1. Compared with the shielding member shown in FIG. 1 (a), embodiments shown in FIG. 8 to FIG. 11 eliminate one thick layer of soft adhesive. A total thickness D10 of the protruding portion 111, the strip portion 1221, and the elastic sheet 121 is small, and the total thickness D10 also remains small when a safety gap D13 (for example, 0.2 millimeters to 0.5 millimeters) exists between the protruding portion 111 and the strip portion 1221. This helps reduce the thickness of the entire foldable device 1000 at a position corresponding to the middle part 1221f of the strip portion 1221. In this embodiment, the protruding portion 111 may be disposed at a low position, so as to avoid hand scraping caused by the protruding portion 111.

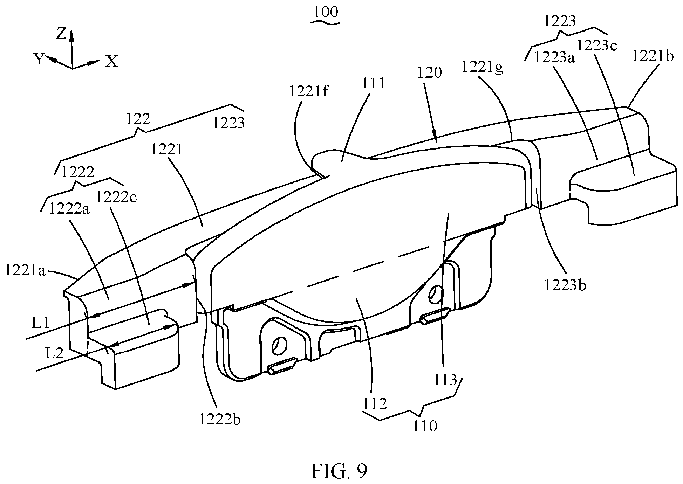

When the flexible body 122 is disposed, as shown in FIG. 9, FIG. 10, and FIG. 16, the strip portion 1221 is provided with a first side edge 1221g facing the fastening member 110, the first connecting portion 1222 is disposed at one end of the first side edge 1221g, and the second connecting portion 1223 is disposed at the other end of the first side edge 1221g. The first side edge 1221g may extend in the X direction.

The first side edge 1221g of the strip portion 1221 is a side surface having a specific area. One end and the other end of the first side edge 1221g correspond to separate regions having specific areas on the first side edge 1221g, so that the first connecting portion 1222 and the second connecting portion 1223 are respectively connected to the two ends of the first side edge 1221g.

The first connecting portion 1222 and the second connecting portion 1223 are correspondingly connected to two opposite ends of the first side edge 1221g that is of the strip portion 1221 and that faces the fastening member 110. With reference to FIG. 12, the first connecting portion 1222 and the second connecting portion 1223 are offset from the side surface 300c of the flexible display 300 along the axial direction (Y direction) of the hinge assembly 200, so that the first connecting portion 1222 and the second connecting portion 1223 are correspondingly embedded in the first main body 400 and the second main body 500. The strip portion 1221 shields and protects the edge of the bending region 302 in the thickness direction (Z direction) of the flexible display 300.

To enable the flexible insert 120 to bend into a uniform form in a bending process, in some embodiments, as shown in FIG. 4, FIG. 13, and FIG. 14, a first sliding groove 401 is provided at the edge 400a that is of the first main body 400 and that is adjacent to the hinge assembly 200, a length direction of the first sliding groove 401 is the same as the length direction (X direction) of the strip portion 1221, and the first connecting portion 1222 is slidably fitted in the first sliding groove 401. A second sliding groove 501 is provided at the edge 500a that is of the second main body 500 and that is adjacent to the hinge assembly 200, a length direction of the second sliding groove 501 is the same as the length direction (X direction) of the strip portion 1221, and the second connecting portion 1223 is slidably fitted in the second sliding groove 501.

In a process in which the foldable device 1000 switches between the unfolded state and the folded state, the first connecting portion 1222 is allowed to slide relative to the first main body 400, and the second connecting portion 1223 is allowed to slide relative to the second main body 500, so that the strip portion 1221 connected between the first connecting portion 1222 and the second connecting portion 1223 may form a uniform bending form. The first connecting portion 1222 is not fastened to the first main body 400, and the second connecting portion 1223 is not fastened to the second main body 500. Under prolonged repeated bending, static bending, or high-temperature and high-humidity conditions, deformation of the flexible insert 120 is small, and the flexible insert 120 is not prone to creasing, or arching, and can be restored to a flat natural form when being in an unfolded state.

When sliding strokes of the first connecting portion 1222 and the second connecting portion 1223 are set, as shown in FIG. 14, the sliding stroke L of the first connecting portion 1222 in the first sliding groove 401 ranges from 0.2 millimeter to 1 millimeter, and the sliding stroke L of the second connecting portion 1223 in the second sliding groove 501 ranges from 0.2 millimeter to 1 millimeter.

The sliding stroke of the first connecting portion 1222 in the first sliding groove 401 refers to a movable distance of the first connecting portion 1222 after the first connecting portion 1222 is installed in the first sliding groove 401. The sliding stroke of the second connecting portion 1223 in the second sliding groove 501 refers to a movable distance of the second connecting portion 1223 after the second connecting portion 1223 is installed in the second sliding groove 501.

The sliding stroke range is set to the foregoing range, so that the first connecting portion 1222 and the second connecting portion 1223 at the two ends (1221a, 1221b) of the strip portion 1221 are correspondingly installed in the first sliding groove 401 and the second sliding groove 501. This enables the strip portion 1221 to form a uniform bending form in a process in which the foldable device 1000 switches between the unfolded state and the folded state, thereby preventing a case in which the flexible insert 120 is detached from the first main body 400 and the second main body 500. In this way, regions of the first main body 400 with the first sliding groove 401 and regions of the second main body 500 with the second sliding groove 501 are endowed with specific structural strength, thereby improving structural reliability.

For example, the sliding stroke L may be 0.2 millimeter, 0.5 millimeter, 0.6 millimeter, 0.8 millimeter, 0.9 millimeter, or 1 millimeter, and is specifically set as required.

When the first connecting portion 1222 is set, as shown in FIG. 9, FIG. 10, FIG. 13, and FIG. 14, the first connecting portion 1222 includes a first supporting portion 1222a and a first sliding portion 1222c. The first supporting portion 1222a is connected between the first side edge 1221g and the first sliding portion 1222c. With reference to FIG. 12, one end that is of the first supporting portion 1222a and that is away from the first side edge 1221g is located in the first sliding groove 401, the first sliding portion 1222c is located in the first sliding groove 401, and cross-sectional shapes of the first sliding portion 1222c and the first sliding groove 401, taken perpendicular to the length direction of the strip portion 1221, are adapted to each other.

That the first supporting portion 1222a is connected between the first side edge 1221g and the first sliding portion 1222c means that a region having a specific area on the first side edge 1221g is connected to the first sliding portion 1222c via the first supporting portion 1222a. The first supporting portion 1222a is connected between the first side edge 1221g of the strip portion 1221 and the first sliding portion 1222c, so that the first sliding portion 1222c may offset by a specific distance along the thickness direction (Z direction) of the flexible display 300, and the first sliding portion 1222c may be slidably fitted on the first main body 400 that is spaced apart from the display surface 300a of the flexible display 300 by a predetermined distance. The first supporting portion 1222a may be disposed in a cuboid or another shape. That the cross-sectional shapes of the first sliding portion 1222c and the first sliding groove 401, taken perpendicular to the length direction of the strip portion 1221, are adapted to each other means that the shapes of the first sliding portion 1222c and the first sliding groove 401 are approximately the same, so that the first sliding portion 1222c can slide steadily in a straight line along the length direction of the first sliding groove 401.

When the first supporting portion 1222a and the first sliding portion 1222c are set, lengths of the first supporting portion 1222a and the first sliding portion 1222c in the X direction may be equal or not equal, and are disposed as required. The length L1 of the first supporting portion 1222a in the X direction is a distance between two opposite end surfaces of the first supporting portion 1222a in the X direction. The length L2 of the first sliding portion 1222c in the X direction is a distance between two opposite end surfaces of the first sliding portion 1222c in the X direction. For example, as shown in FIG. 9, the length L1 of the first supporting portion 1222a in the X direction is greater than the length L2 of the first sliding portion 1222c in the X direction.

To prevent the first connecting portion 1222 from being detached from the first sliding groove 401 to improve reliability, in some embodiments, as shown in FIG. 9, FIG. 10, FIG. 13, and FIG. 14, in the length direction (X direction) of the strip portion 1221, the end surface 1222b that is of the first supporting portion 1222a and that is adjacent to the fastening member 110 and the end surface 401a of the first sliding groove 401 are disposed facing each other. In a process in which the foldable device 1000 switches between the unfolded state and the folded state, the first connecting portion 1222 is slidably fitted in the first sliding groove 401. The end surface 401a of the first sliding groove 401 abuts against the end surface 1222b of the first supporting portion 1222a, so that the first supporting portion 1222a cannot continue to move, limiting a moving range of the first connecting portion 1222, and preventing the first connecting portion 1222 from being detached from the first sliding groove 401.

When the cross-sectional shapes of the first sliding portion 1222c and the first sliding groove 401 are set, as shown in FIG. 9, FIG. 10, and FIG. 12, the cross-sectional shapes of the first sliding portion 1222c and the first sliding groove 401, taken perpendicular to the length direction (X direction) of the strip portion 1221, are each bent and extended. When the first sliding portion 1222c is installed in the first sliding groove 401, the first sliding portion 1222c is snapped onto the first sliding groove 401 along the axial direction (Y direction) of the hinge assembly 200, so that the first sliding portion 1222c is not prone to detaching from the first main body 400 along the axial direction (Y direction) of the hinge assembly 200, and the flexible insert 120 is kept on the first main body 400.

For example, as shown in FIG. 12, the cross-sectional shapes of the first sliding portion 1222c and the first sliding groove 401, taken perpendicular to the length direction (X direction) of the strip portion 1221, are each bent extending shapes such as an L shape and an arc shape, so that the first sliding portion 1222c can be snapped to the first sliding groove 401 along the axial direction (Y direction) of the hinge assembly 200 without being prone to be detached.

When the second connecting portion 1223 is set, as shown in FIG. 9 and FIG. 13 to FIG. 15, the second connecting portion 1223 includes a second supporting portion 1223a and a second sliding portion 1223c, the second supporting portion 1223a is connected between the first side edge 1221g and the second sliding portion 1223c, an end that is of the second supporting portion 1223a and that is away from the first side edge 1221g is located in the second sliding groove 501, the second sliding portion 1223c is located in the second sliding groove 501, and cross-sectional shapes of the second sliding portion 1223c and the second sliding groove 501, taken perpendicular to the length direction (X direction) of the strip portion 1221, are adapted to each other.

That the second supporting portion 1223a is connected between the first side edge 1221g and the second sliding portion 1223c means that a region having a specific area on the first side edge 1221g is connected to the second sliding portion 1223c via the second supporting portion 1223a.

The second supporting portion 1223a is connected between the first side edge 1221g of the strip portion 1221 and the second sliding portion 1223c, so that the second sliding portion 1223c may offset by a specific distance along the thickness direction (Z direction) of the flexible display 300, and the second sliding portion 1223c may be slidably fitted on the second main body 500 that is spaced apart from the display surface 300a of the flexible display 300 by a predetermined distance. The second supporting portion 1223a may be disposed in a cuboid or another shape. That the cross-sectional shapes of the second sliding portion 1223c and the second sliding groove 501, taken perpendicular to the length direction (X direction) of the strip portion 1221, are adapted to each other means that the shapes of the second sliding portion 1223c and the second sliding groove 501 are approximately the same, so that the second sliding portion 1223c can slide steadily in a straight line along the length direction of the second sliding groove 501.

When the second supporting portion 1223a and the second sliding portion 1223c are set, lengths of the second supporting portion 1223a and the second sliding portion 1223c in the X direction may be equal or not equal, and are disposed as required. The length of the second supporting portion 1223a in the X direction is a distance between two opposite end surfaces of the second supporting portion 1223a in the X direction. The length of the second sliding portion 1223c in the X direction is a distance between two opposite end surfaces of the second sliding portion 1223c in the X direction. For example, as shown in FIG. 9, the length of the second supporting portion 1223a in the X direction is greater than the length of the second sliding portion 1223c in the X direction.

To prevent the second connecting portion 1223 from being detached from the second sliding groove 501 to improve reliability, in some embodiments, as shown in FIG. 9, FIG. 13, and FIG. 14, in the length direction (X direction) of the strip portion 1221, the end surface 1223b that is of the second supporting portion 1223a and that is adjacent to the fastening member 110 and the end surface 501a of the second sliding groove 501 are disposed facing each other. In a process in which the foldable device 1000 switches between the unfolded state and the folded state, the second connecting portion 1223 is slidably fitted in the second sliding groove 501. The end surface 501a of the second sliding groove 501 abuts against the end surface 1223b of the second supporting portion 1223a, so that the second supporting portion 1223a cannot continue to move, limiting a moving range of the second connecting portion 1223, and preventing the second connecting portion 1223 from being detached from the second sliding groove 501.

When the cross-sectional shapes of the second sliding portion 1223c and the second sliding groove 501 are set, as shown in FIG. 9, FIG. 13, and FIG. 14, the cross-sectional shapes of the second sliding portion 1223c and the second sliding groove 501, taken perpendicular to the length direction (X direction) of the strip portion 1221, are each bent and extended. When the second sliding portion 1223c is installed in the second sliding groove 501, the second sliding portion 1223c is snapped onto the second sliding groove 501 along the axial direction (Y direction) of the hinge assembly 200, thereby preventing the second sliding portion 1223c from being prone to detaching from the second main body 500 along the axial direction (Y direction) of the hinge assembly 200, and maintaining the flexible insert 120 on the second main body 500.

For example, as shown in FIG. 9, FIG. 13, and FIG. 14, cross-sectional shapes of the second sliding portion 1223c and the second sliding groove 501, taken perpendicular to the length direction of the strip portion 1221, are each bent extending shapes such as an L-shape and an arc shape, so that the second sliding portion 1223c can be snapped onto the second sliding groove 501 along the axial direction (Y direction) of the hinge assembly 200 without being prone to be detached.

When positions of the fastening member 110, the first connecting portion 1222, and the second connecting portion 1223 are set, as shown in FIG. 9, in the length direction (X direction) of the strip portion 1221, the fastening member 110 may be located between the first connecting portion 1222 and the second connecting portion 1223, so that the strip portion 1221 between the first connecting portion 1222 and the second connecting portion 1223 may be shortened, thereby enabling the strip portion 1221 to cover the edge of the bending region 302 of the display surface 300a of the flexible display 300, to implement shielding and protection. In the length direction (X direction) of the strip portion 1221, the fastening member 110 may be located between the first supporting portion 1222a in the first connecting portion 1222 and the second supporting portion 1223a in the second connecting portion 1223, so that the thickness of the fastening member 110 may be thinned, and the fastening member 110 is fastened to the end portion 200a of the hinge assembly 200, and occupies small space of the hinge assembly 200.

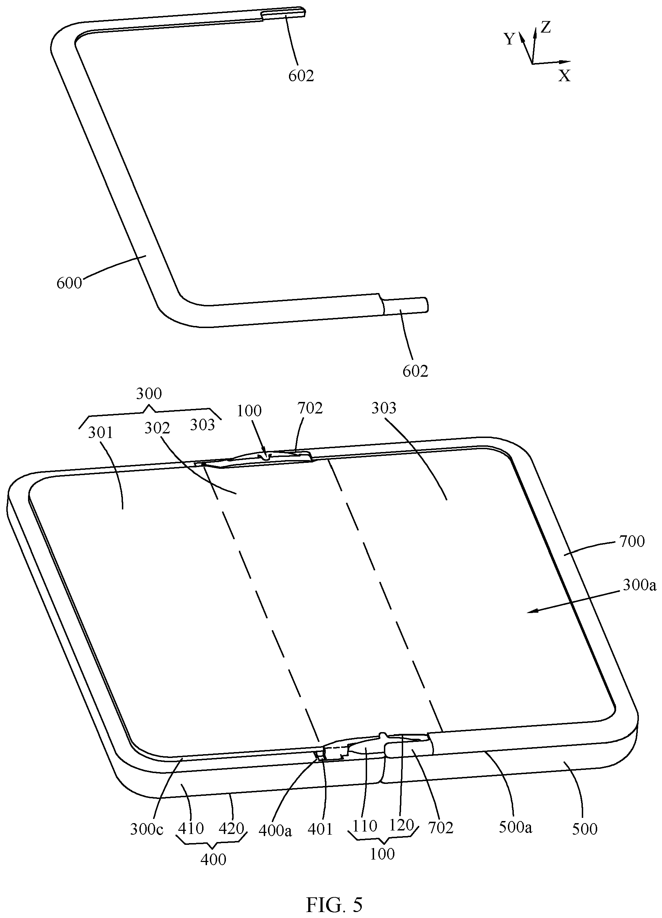

When the first connecting portion 1222 and the second connecting portion 1223 in the flexible insert 120 are assembled, as shown in FIG. 12, in the thickness direction (Z direction) of the flexible display 300, the first connecting portion 1222 is located between the first side frame 600 and the first main body 400. With reference to FIG. 5 and FIG. 9, the second connecting portion 1223 is located between the second side frame 700 and the second main body 500.

The first connecting portion 1222 is kept between the first side frame 600 and the first main body 400, and the second connecting portion 1223 is kept between the second side frame 700 and the second main body 500, so that the strip portion 1221 and the elastic sheet 121 between the first connecting portion 1222 and the second connecting portion 1223 can be kept at a predetermined position and cannot be prone to be detached, and the flexible insert 120 is reliably assembled between the first main body 400 and the second main body 500, so that the flexible insert 120 can perform folding protection on the edge of the bending region 302 of the display surface 300a of the flexible display 300.

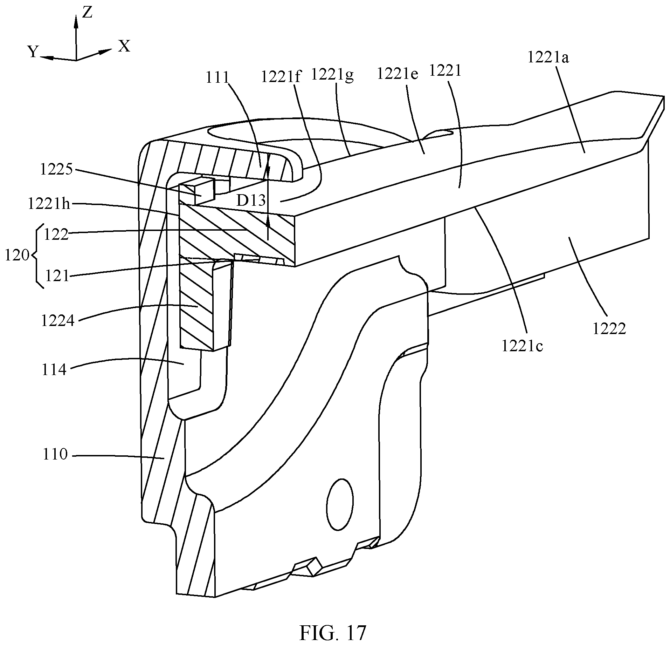

To prevent detachment of the flexible insert 120 from the flexible display 300, in some embodiments, as shown in FIG. 8, FIG. 10, FIG. 11, and FIG. 17, a first limiting portion 1224 is connected to a side that is of the middle part 1221h of the first side edge 1221g of the strip portion 1221 and that faces the flexible display 300, and the first limiting portion 1224 and the side surface 300c of the flexible display 300 are disposed facing each other.

That the first limiting portion 1224 is connected to the side that is of the middle part 1221h of the first side edge 1221g and that faces the flexible display 300 means that a region having a specific area of the side that is of the middle part 1221h of the first side edge 1221g and that faces the flexible display 300 is connected to the first limiting portion 1224.

The first limiting portion 1224 in the middle of the strip portion 1221 and the side surface 300c of the flexible display 300 are disposed facing each other at an interval, and the first limiting portion 1224 and the side surface 300c of the flexible display 300 have a specific avoidance distance without contact. The first limiting portion 1224 abuts against the side surface 300c of the flexible display 300 under an external force, to prevent the flexible insert 120 from being detached from the flexible display 300 under an external force, so that the flexible insert 120 is kept at a predetermined position, to shield and protect the edge of the bending region 302 of the display surface 300a of the flexible display 300, thereby improving reliability. The first limiting portion 1224 may be in a sheet shape or another shape. The first limiting portion 1224 and the strip portion 1221 may be of an integrally formed structure, and may be made of a same material.

On a basis that the middle part 1221h of the first side edge 1221g of the strip portion 1221 is connected to the first limiting portion 1224, as shown in FIG. 8, FIG. 10, and FIG. 11, a side that is of the fastening member 110 and that faces the flexible display 300 may have an avoidance groove 114, and the first limiting portion 1224 is at least partially embedded in the avoidance groove 114. A part of the first limiting portion 1224 is embedded in the avoidance groove 114 of the fastening member 110, and space in the thickness direction of the fastening member 110 is used, so that a size of the foldable device 1000 in the axial direction (Y direction) of the hinge assembly 200 may be small. The first limiting portion 1224 and an inner wall of the avoidance groove 114 are disposed facing each other. In a process in which the first main body 400 and the second main body 500 drive the strip portion 1221 to bend, the first limiting portion 1224 and the inner wall of the avoidance groove 114 gradually approach each other to abut against each other, so that the bending form of the strip portion 1221 can be limited.

In some other embodiments, the first limiting portion 1224 may not be disposed in the middle part 1221h of the first side edge 1221g of the strip portion 1221, and the first supporting portion 1222a and the second supporting portion 1223a are separately disposed facing the side surface 300c of the flexible display 300, so as to prevent the flexible insert 120 from being detached from the flexible display 300.

To improve falling reliability of the foldable device 1000, the flexible insert 120 has a good bending form. In some embodiments, as shown in FIG. 8, FIG. 10, FIG. 11, and FIG. 17, there is a safety gap D13 between the strip portion 1221 and the protruding portion 111, and a second limiting portion 1225 is connected to a side that is of the middle part 1221h of the first side edge 1221g and that faces away from the flexible display 300, and in the thickness direction (Z direction) of the flexible display 300, the second limiting portion 1225 and the protruding portion 111 are disposed facing each other.

That the second limiting portion 1225 is connected to the side that is of the middle part 1221h of the first side edge 1221g and that faces away from the flexible display 300 means that a region having a specific area of the side that is of the middle part 1221h of the first side edge 1221g and that faces away from the flexible display 300 is connected to the second limiting portion 1225.

When the foldable device 1000 is in the unfolded state, in the thickness direction (Z direction) of the flexible display 300, there is a safety gap D13 between the protruding portion 111 and the strip portion 1221, for example, 0.2 millimeter to 0.5 millimeter. There is a specific avoidance distance between the protruding portion 111 and the second limiting portion 1225, for example, 0.1 millimeter. When the foldable device 1000 is dropped, the flexible display 300 is permitted to undergo a specific degree of deformation and vibration, thereby preventing crush damage to the flexible display 300 from the protruding portion 111 of the fastening member 110. A second limiting portion 1225 is disposed in a middle part 1221h of the first side edge 1221g of the strip portion 1221. At a moment when the foldable device 1000 in the unfolded state is folded, the second limiting portion 1225 presses against the protruding portion 111, so that the middle part 1221f of the strip portion 1221 is not prone to be arched. Then, the strip portion 1221 and the elastic sheet 121 are bent gradually, so that the flexible insert 120 has a good bending form in a bending process, and user experience is better. When the flexible insert 120 is subjected to an external force, the second limiting portion 1225 may abut against the protruding portion 111 of the fastening member 110, so as to prevent the flexible insert 120 from being detached along the axial direction (Y direction) of the hinge assembly 200, and improve reliability. The second limiting portion 1225 may be in a rectangular block shape or another shape. In the thickness direction (Z direction) of the flexible display 300, the second limiting portion 1225 is located below the protruding portion 111, the second limiting portion 1225 is covered by the protruding portion 111, and the second limiting portion 1225 is not prone to be seen from outside, and an appearance effect is not affected. The second limiting portion 1225 and the strip portion 1221 may be of an integrally formed structure, and may be made of a same material.

On a basis that the middle part 1221h of the first side edge 1221g is connected to the second limiting portion 1225, as shown in FIG. 8, FIG. 10, and FIG. 11, a side that is of the fastening member 110 and that faces the flexible display 300 is provided with an avoidance groove 114, and the second limiting portion 1225 is at least partially embedded in the avoidance groove 114. A part of the second limiting portion 1225 is embedded in the avoidance groove 114 of the fastening member 110, and space in the thickness direction of the fastening member 110 is used, so that a size of the foldable device 1000 in the axial direction (Y direction) of the hinge assembly 200 may be small.

In some other embodiments, a side that is of the middle part 1221h of the first side edge 1221g and that faces away from the flexible display 300 may not be connected to the second limiting portion 1225.

In some embodiments, as shown in FIG. 2 and FIG. 12, in the thickness direction (Z direction) of the flexible display 300, a first gap 611 is formed between the first side frame 600 and the display surface 300a of the flexible display 300, and a second gap 612 is formed between the second side frame 700 and the display surface 300a of the flexible display 300. One end 1221a of the strip portion 1221 is located in the first gap 611, and the other end 1221b of the strip portion 1221 is located in the second gap 612.

One end 1221a of the strip portion 1221 is disposed between the first side frame 600 and the flexible display 300, and the other end 1221b is disposed between the second side frame 700 and the flexible display 300, to achieve position limitation of the two ends of the strip portion 1221. The two ends (1221a, 1221b) of the strip portion 1221 are covered by the first side frame 600 and the second side frame 700, to improve an appearance effect.

To prevent the flexible insert 120 from being prone to detaching from the edge of the flexible display 300, in some embodiments, as shown in FIG. 9 and FIG. 12, in the axial direction (Y direction) of the hinge assembly 200, a third gap 613 is formed between the first side frame 600 and the side surface 300c of the flexible display 300. With reference to FIG. 5, a fourth gap (not shown in the figure) is formed between the second side frame 700 and the side surface 300c of the flexible display 300. A part of the first connecting portion 1222 (that is, the first supporting portion 1222a in the first connecting portion 1222) is located in the third gap 613, and a part of the second connecting portion 1223 (that is, the second supporting portion 1223a in the second connecting portion 1223) is located in the fourth gap.

In a process in which the foldable device 1000 switches between the unfolded state and the folded state, the middle part 1221f of the strip portion 1221 of the flexible insert 120 is limited by the protruding portion 111 of the fastening member 110, and a part of the first connecting portion 1222 (a part of the second connecting portion 1223) of the flexible body 122 is disposed in a gap between the first side frame 600 (the second side frame 700) and the side surface 300c of the flexible display 300, so that the two ends of the flexible insert 120 move with the first main body 400 and the second main body 500, and the flexible insert 120 is kept at an edge of the flexible display 300 and is not prone to be detached, to reliably shield and protect the edge of the flexible display 300, and prevent the flexible insert 120 from being detached under action of an external force.

In some embodiments, as shown in FIG. 2, FIG. 4, and FIG. 5, there is a first shielding portion 602 at a position that is of the first side frame 600 and that is close to the hinge assembly 200, and there is a second shielding portion 702 at a position that is of the second side frame 700 and that is close to the hinge assembly 200. In the axial direction (Y direction) of the hinge assembly 200, a projection of the first shielding portion 602 partially covers the fastening member 110, and a projection of the second shielding portion 702 partially covers the fastening member 110, to protect the fastening member 110. FIG. 5 shows that after the first side frame 600 is detached from the foldable device 1000, the fastening member 110 is not shielded by the first shielding portion 602, the second side frame 700 is installed on the second main body 500, and a part of a surface of the fastening member 110 is shielded by the second shielding portion 702 of the second side frame 700.

In the axial direction (Y direction) of the hinge assembly 200, the first shielding portion 602 of the first side frame 600 and the second shielding portion 702 of the second side frame 700 can cover a part of a surface of a side that is of the fastening member 110 and that faces away from the flexible display 300. This protects the fastening member 110, prevents an external foreign object, such as a particle, from entering a gap between the fastening member 110 and the hinge assembly 200, improves reliability, and improves an appearance of the end portion 200a of the hinge assembly 200. The first shielding portion 602 and the second shielding portion 702 may be in a strip shape. When the foldable device 1000 is in the unfolded state, an end portion 200a of the first shielding portion 602 and an end portion 200a of the second shielding portion 702 are disposed opposite to each other.

During confirmation of the edge protection assembly 100 and the foldable device 1000 in embodiments of this application, the device may be disassembled for analysis. When a to-be-confirmed object is the edge protection assembly 100, it is to be confirmed that the flexible insert 120 in the edge protection assembly 100 includes an elastic sheet 121 and a flexible body 122, and the elastic sheet 121 and the flexible body 122 are of an integrally formed structure. The flexible body 122 includes a strip portion 1221, a first connecting portion 1222, and a second connecting portion 1223. The first connecting portion 1222 is connected to one end 1221a of the strip portion 1221, the second connecting portion 1223 is connected to the other end 1221b of the strip portion 1221, and the elastic sheet 121 is embedded within the strip portion 1221. The first surface 1221c of the strip portion 1221 and the edge of the bending region 302 of the display surface 300a of the flexible display 300 are disposed facing each other, and the protruding portion 111 of the fastening member 110 and the second surface 1221e of the strip portion 1221 are disposed facing each other at the middle part 1221f of the strip portion 1221 in the length direction. When the to-be-confirmed object is a device, it is to be confirmed that the device has a foldable flexible display 300, and the edge protection assembly 100 is disposed between the first main body 400 and the second main body 500.

In conclusion, the foregoing descriptions are merely specific implementations of this application, but are not intended to limit the protection scope of this application. Any variation or replacement within the technical scope disclosed in this application shall fall within the protection scope of this application. Therefore, the protection scope of this application shall be subject to the protection scope of the claims.

## Claims

1. An edge protection assembly, applied to a foldable device having a hinge assembly, a first main body, a second main body, and a flexible display, wherein the hinge assembly is located between the first main body and the second main body, the first main body and the second main body are connected through the hinge assembly, the flexible display has a display surface and a back surface that face away from each other, and the back surface of the flexible display is fastened to the first main body and the second main body; and the edge protection assembly comprises a fastening member and a flexible insert;
the fastening member is configured to be fastened to the hinge assembly; in an axial direction of the hinge assembly, a projection of the fastening member covers a part of a side surface of the flexible display; and the fastening member has a protruding portion;
the flexible insert comprises an elastic sheet and a flexible body, wherein the elastic sheet and the flexible body are of an integrally formed structure; the flexible body comprises a strip portion, a first connecting portion, and a second connecting portion; and the first connecting portion is connected to one end of the strip portion, the second connecting portion is connected to the other end of the strip portion, and the elastic sheet is embedded in the strip portion;
the strip portion has a first surface and a second surface that face away from each other, the first surface and an edge of a bending region of the display surface of the flexible display are disposed opposite to each other, and the protruding portion and the second surface are disposed opposite to each other at a middle part of the strip portion in a length direction; and
the first connecting portion is configured to be embedded in an edge of the first main body, and the second connecting portion is configured to be embedded in an edge of the second main body.

2. The edge protection assembly according to claim 1, wherein the elastic sheet is a plastic sheet or a metal sheet, a material of the flexible body is soft adhesive, and the elastic sheet and the flexible body are of an insert molded structure.

3. The edge protection assembly according to claim 1 or 2, wherein the elastic sheet is disposed on the first surface; and/or
there is a first recess on the first surface, and the elastic sheet is embedded in the first recess.

4. The edge protection assembly according to any one of claims 1 to 3, wherein the strip portion has a first side edge facing the fastening member, the first connecting portion is disposed at one end of the first side edge, and the second connecting portion is disposed at the other end of the first side edge.

5. The edge protection assembly according to claim 4, wherein an edge of the first main body close to the hinge assembly has a first sliding groove, a length direction of the first sliding groove is the same as the length direction of the strip portion, and the first connecting portion is slidably fitted in the first sliding groove; and
an edge of the second main body close to the hinge assembly has a second sliding groove, a length direction of the second sliding groove is the same as the length direction of the strip portion, and the second connecting portion is slidably fitted in the second sliding groove.

6. The edge protection assembly according to claim 5, wherein a sliding stroke of the first connecting portion in the first sliding groove ranges from 0.2 millimeter to 1 millimeter, and a sliding stroke of the second connecting portion in the second sliding groove ranges from 0.2 millimeter to 1 millimeter.

7. The edge protection assembly according to claim 5 or 6, wherein the first connecting portion comprises a first supporting portion and a first sliding portion, the first supporting portion is connected between the first side edge and the first sliding portion, one end that is of the first supporting portion and that is away from the first side edge is located in the first sliding groove, and the first sliding portion is located in the first sliding groove; and cross-sectional shapes of the first sliding portion and the first sliding groove, taken perpendicular to the length direction of the strip portion, are adapted to each other.

8. The edge protection assembly according to claim 7, wherein in the length direction of the strip portion, an end surface of the first supporting portion close to the fastening member and an end surface of the first sliding groove are disposed facing each other; and/or
the cross-sectional shapes of the first sliding portion and the first sliding groove, taken perpendicular to the length direction of the strip portion, are each bent and extended.

9. The edge protection assembly according to any one of claims 4 to 8, wherein a first limiting portion is connected to a side of the middle part of the first side edge facing the flexible display, and the first limiting portion and a side surface of the flexible display are disposed facing each other; and/or
a safety gap is provided between the strip portion and the protruding portion, a second limiting portion is connected to the side of the middle part of the first side edge facing away from the flexible display, and in a thickness direction of the flexible display, the second limiting portion and the protruding portion are disposed facing each other.

10. The edge protection assembly according to claim 9, wherein the fastening member has an avoidance groove on a side facing the flexible display, and at least part of the first limiting portion and/or at least part of the second limiting portion are/is embedded in the avoidance groove.

11. A foldable device, comprising: a hinge assembly, a first main body, a second main body, a flexible display, and the edge protection assembly according to any one of claims 1 to 10, wherein
the hinge assembly is located between the first main body and the second main body, and the first main body and the second main body are connected through the hinge assembly; and
the flexible display has a display surface and a back surface that face away from each other, and the back surface of the flexible display is fastened to the first main body and the second main body; and
the first connecting portion is embedded in an edge of the first main body, and the second connecting portion is embedded in an edge of the second main body.

12. The foldable device according to claim 11, wherein a first side frame is disposed on the first main body, and the first side frame is disposed on an edge that is of the flexible display and that corresponds to the first main body; a second side frame is disposed on the second main body, and the second side frame is disposed on an edge that is of the flexible display and that corresponds to the second main body; and the flexible insert is located between the first side frame and the second side frame.

13. The foldable device according to claim 12, wherein in a thickness direction of the flexible display, the first connecting portion is located between the first side frame and the first main body, and the second connecting portion is located between the second side frame and the second main body.

14. The foldable device according to claim 12 or 13, wherein in the thickness direction of the flexible display, a first gap is formed between the first side frame and the display surface of the flexible display, and a second gap is formed between the second side frame and the display surface of the flexible display; and one end of the strip portion is located in the first gap, and the other end of the strip portion is located in the second gap.

15. The foldable device according to any one of claims 12 to 14, wherein in an axial direction of the hinge assembly, a third gap is formed between the first side frame and a side surface of the flexible display, and a fourth gap is formed between the second side frame and the side surface of the flexible display; and the first connecting portion is partially located in the third gap, and the second connecting portion is partially located in the fourth gap.

16. The foldable device according to any one of claims 12 to 15, wherein there is a first shielding portion at a position that is of the first side frame and that is close to the hinge assembly, and there is a second shielding portion at a position that is of the second side frame and that is close to the hinge assembly; and in the axial direction of the hinge assembly, a projection of the first shielding portion partially covers the fastening member, and a projection of the second shielding portion partially covers the fastening member.
